**Europäisches Patentamt**

**European Patent Office**

**Office européen des brevets**

(19)

(11) Veröffentlichungsnummer: **0 038 947**
**B1**

(12) **EUROPÄISCHE PATENTSCHRIFT**

(45) Veröffentlichungstag der Patentschrift:
**21.08.85**

(21) Anmeldenummer: **81102417.3**

(22) Anmeldetag: **31.03.81**

(51) Int. Cl.⁴: **H 03 K 19/177**, G 06 F 11/26,
G 01 R 31/28

(54) **Programmierbare logische Anordnung.**

(30) Priorität: **25.04.80 DE 3015992**

(43) Veröffentlichungstag der Anmeldung:
**04.11.81 Patentblatt 81/44**

(45) Bekanntmachung des Hinweises auf die Patenterteilung:
**21.08.85 Patentblatt 85/34**

(84) Benannte Vertragsstaaten:
**DE FR GB**

(56) Entgegenhaltungen:
DE - A - 2 550 342
US - A - 3 958 110
US - A - 3 987 286
US - A - 4 177 452

IEEE TRANSACTIONS ON COMPUTERS, Band C-30, Nr. 3, März 1981 New York, USA M. TANAKA et al. "Rewritable Programmable Logic Array of Current Mode Logic" Seiten 229 bis 234
Patent Abstracts of Japan, Band 4, Nr. 32, 19 März 1980, Seite 115E2
Patent Abstracts of Japan Band 4, Nr. 36, 26. März 1980 Seite 68E3
IBM TECHNICAL DISCLOSURE BULLETIN, Band 19, Nr. 2, Juli 1976, New York J.C. LOGUE et al. "Programmable Logic Array Error Detection and Error Correction" Seiten 588 bis 590
SECOND EUROMICRO SYMPOSIUM ON:
Microprocessing and Microprogramming 12. bis 14. Oktober 1976 in Venedig North-Holland Publishing Company H.M. LIPP "Array Logic" Seiten 57 bis 64

(73) Patentinhaber: **IBM DEUTSCHLAND GMBH,
Pascalstrasse 100, D-7000 Stuttgart 80 (DE)**

(84) Benannte Vertragsstaaten: **DE**

(73) Patentinhaber: **International Business Machines
Corporation, Old Orchard Road, Armonk, N.Y. 10504 (US)**

(84) Benannte Vertragsstaaten: **FR GB**

(72) Erfinder: **Götze, Volkmar, Malteserstrasse 69,
D-7031 Grafenau 2 (DE)**
Erfinder: **Schütt, Dieter, Dr., Fallmerayerstrasse 17,
D-8000 München 40 (DE)**

(74) Vertreter: **Lewit, Leonard, Dipl.-Ing., Schönaicher
Strasse 220, D-7030 Böblingen (DE)**

**0 038 947**

## Beschreibung

Die Erfindung bezieht sich auf eine programmierbare logische Anordnung (PLA) und insbesondere auf das Testen und Laden einer PLA, die aus einer UND-Matrix und einer ODER-Matrix aufgebaut ist und in der die Kreuzungspunkte in den Matrizen von Speicherkippschaltungen gesteuert werden.

An den Eingang einer solchen PLA werden die einer Anzahl von binären Variablen entsprechenden Signale angelegt und abhängig von der einprogrammierten Aktivierung der Kreuzungspunkte in den beiden Matrizen werden dann auf bestimmten Ausgangsleitungen (Funktionsleitungen) Ausgangssignale erhalten. Als bevorzugte Anwendung einer solchen PLA kann die Verwendung als Funktionssteuerung in einer Datenverarbeitungsanlage genannt werden. Dabei werden an den Eingang der PLA die binären Operationssignale einer Instruktion angelegt und wird der Datenfluß mit Hilfe der Ausgangssignale auf bestimmten Funktionsleitungen gesteuert.

Durch die Möglichkeiten der Großintegration (LSI) können relativ große PLA's mitsamt den Speicherkippschaltungen auf einem Chip realisiert werden. Dies bringt jedoch mit sich, daß die Ausgangsleitungen der UND-Matrix, die zugleich die Eingangsleitungen zur ODER-Matrix bilden und »Produktleitungen« genannt werden, von außen nicht mehr zugänglich sind. Hierdurch wird das Testen einer PLA erheblich erschwert. Dieses Testen kann entweder während, oder nach Abschluß der Fabrikation erfolgen, oder aber auch während des Betriebes der PLA in einer Datenverarbeitungsanlage. Hierbei wird vor allem versucht, festzustellen, ob eine Leitung oder ein Transistor im Kreuzungspunkt einer Matrix »eingerastet« ist. Eine Leitung kann beispielsweise einen Kurzschluß nach Masse oder nach der Versorgungsspannung aufweisen. Meist nimmt auch eine unterbrochene Leitung eines dieser beiden Potentiale an. Enthalten die Knoten der Matrizen, d. h. die in einem Kreuzungspunkt vorhandenen Einrichtungen, einen mit einer oder beiden Leitungen des Kreuzungspunktes verbundenen Transistor, so kann dieser Transistor im Fehlerfalle entweder unterbrochen sein, oder einen Kurzschluß aufweisen und damit die mit ihm verbundene Leitung auf eines der beiden Speisungspotentiale bringen.

Von einigen wenigen Ausnahmen abgesehen kann eine PLA während ihres Betriebes in der Datenverarbeitungsanlage nicht auf fehlerfreie Arbeitsweise überprüft werden. Die Überprüfung erfolgte bisher zumeist entweder vor dem Einbau der PLA in die Datenverarbeitungsanlage durch Anlegen bestimmter Prüfsignale und Vergleich der Ausgangssignale mit bekannten Soll-Werten oder durch Unterbrechungen des normalen Betriebes mit einer Diagnoseroutine, welche ebenfalls dem Eingang der PLA Prüfmuster zuführte. Als Stand der Technik kann hierzu beispielsweise auf die US-PS 3 958 110 und auf die theoretische Abhandlung von OSTAPCO und HONG in »Conference on Fault-Tolerant Computing«, FTCS-8, Toulouse, 21. bis 23. Juni 1978, Seiten 83 bis 89, verwiesen werden. Diese bekannten Einrichtungen können also die PLA nur außerhalb des normalen Betriebes prüfen, oder aber wenn eine längere Unterbrechung des Betriebes in Kauf genommen wird. Außerdem sind diese bekannten Methoden nicht für eine PLA mit Speicherkippschaltungen in den Kreuzungspunkten geeignet, da sie die für eine solche PLA charakteristische Möglichkeit einer dynamischen Personalisierung nicht ausnutzen. Vielmehr erfordert die vollständige Überprüfung der PLA das Anlegen einer sehr großen Anzahl von Prüfsignalkombinationen und damit eine lange Prüfzeit.

Aus der US-PS 3 987 286 ist eine aus zwei hintereinander geschalteten Matrizen bestehende logische Anordnung bekanntgeworden. Die Kreuzungspunkte jeweils einer der Matrizen könne durch ladbare Kippschaltungen personalisiert werden, während die andere Matrix fest personalisiert ist. In einer ersten Ausführungsform ist die Eingangsmatrix der Anordnung als Decodierer ausgeführt, welcher auf einer einzigen von mehreren Leitungen ein Signal abgibt, abhängig davon, welche Kombination von binären Eingangsvariablen anliegt. Die Leitungen stellen die Eingänge einer ODER-Matrix dar, deren als UND-Glieder ausgeführte Kreuzungspunkte von Kippschaltungen konditioniert werden. Hierzu werden die einer Ausgangsleitung der ODER-Matrix entsprechenden UND-Glieder jeweils von einem Schieberegister gesteuert und somit die ODER-Matrix personalisiert.

Gemäß einer zweiten Ausführungsform werden die Kreuzungspunkte der als Decodierer wirkenden Eingangsmatrix von einem durchlaufenden Schieberegister gesteuert. Die Kreuzungspunkte der ODER-Matrix werden dabei von Taktpulsen gesteuert.

Zum Testen der ODER-Matrix können die Schieberegister gemäß der ersten Ausführungsform alle hintereinandergeschaltet und kann ein bestimmtes Prüfmuster hindurchgeschoben werden.

Mit dieser bekannten Einrichtung, welche im übrigen wesentliche Unterschiede gegenüber einer PLA aufweist, da die Eingangsmatrix als Decodierer ausgeführt ist, kann keine systematische Überprüfung auf eine eingerastete Leitung durchgeführt werden. Da in dieser Patentschrift keine Angaben über den Kreuzungspunkt gemacht sind, können hieraus auch keine Lehren für die Feststellung eines eingerasteten Transistors gezogen werden. Zweck des beschriebenen Testverfahrens ist lediglich die Feststellung, ob die logische Anordnung brauchbar ist oder nicht. Die mit einer Fehlerkorrektur zusammenhängenden Probleme sind nicht Gegenstand der Patentschrift.

Eine PLA mit Transistoren in den Kreuzungspunkten ist aus dem IBM Technical Disclosure Bulletin, Juli 1976, Seiten 588 bis 590, bekanntgeworden. Hierbei ist die Basis jedes der Transistoren mit der Eingangsleitung und der Emitter der Transistoren mit der Ausgangsleitung, die in diesem Artikel Wortleitung genannt ist, verbunden. Für jede Wortleitung ist ein weiterer Transistor vorgesehen, der leitend wird, wenn ein mit dieser Leitung verbundener Kreuzungspunkttransistor einen Kurzschluß

2

zwischen Basis und Emitter aufweist. Diese bekannte Einrichtung ermöglicht insofern eine Fehlerkorrektur als zu den Wortleitungen weitere Ersatzleitungen und zu den Ausgangsleitungen der ODER-Matrix eine weitere Ersatzausgangsleitung vorgesehen ist. In diesen Ausgangsleitungen kann ein beliebiges binäres Muster gespeichert werden, da der Kreuzungspunkt zwischen der Ersatzleitung und der damit verbundenen PLA-Leitung von einem Speicherelement gesteuert wird. Die Speicherelemente in den Ersatzleitungen sind dabei zu einem Schieberegister zusammengefaßt. Diese bekannte Einrichtung gestattet also nur die Feststellung von ganz speziellen Fehlern, nämlich die Einrastung eines Transistors auf den leitenden Zustand. Da die Kreuzungspunkte in den Matrizen dieser PLA, welche die gewünschten binären Funktionen realisieren, nicht mit Speicherelementen ausgerüstet sind, kann diese Einrichtung nicht die Vorteile der dynamischen Personalisierung einer PLA mit Speicherelementen in Kreuzungspunkten ausnutzen. Eine systematische und vollständige Überprüfung der PLA ist mit dieser bekannten Einrichtung nicht möglich.

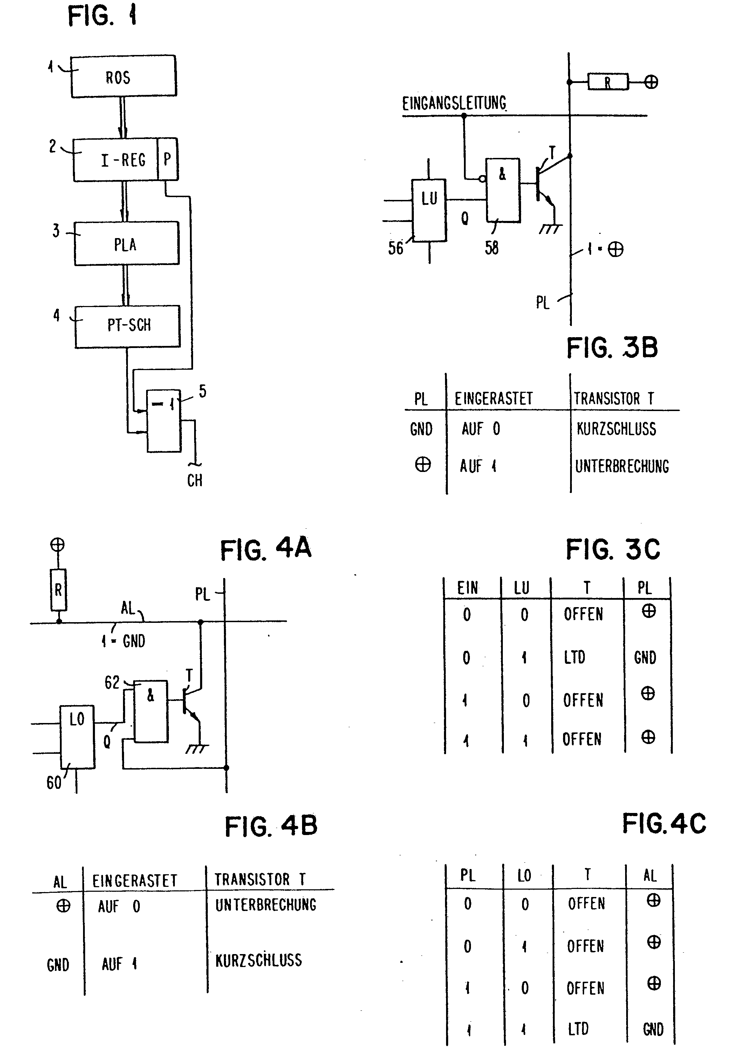

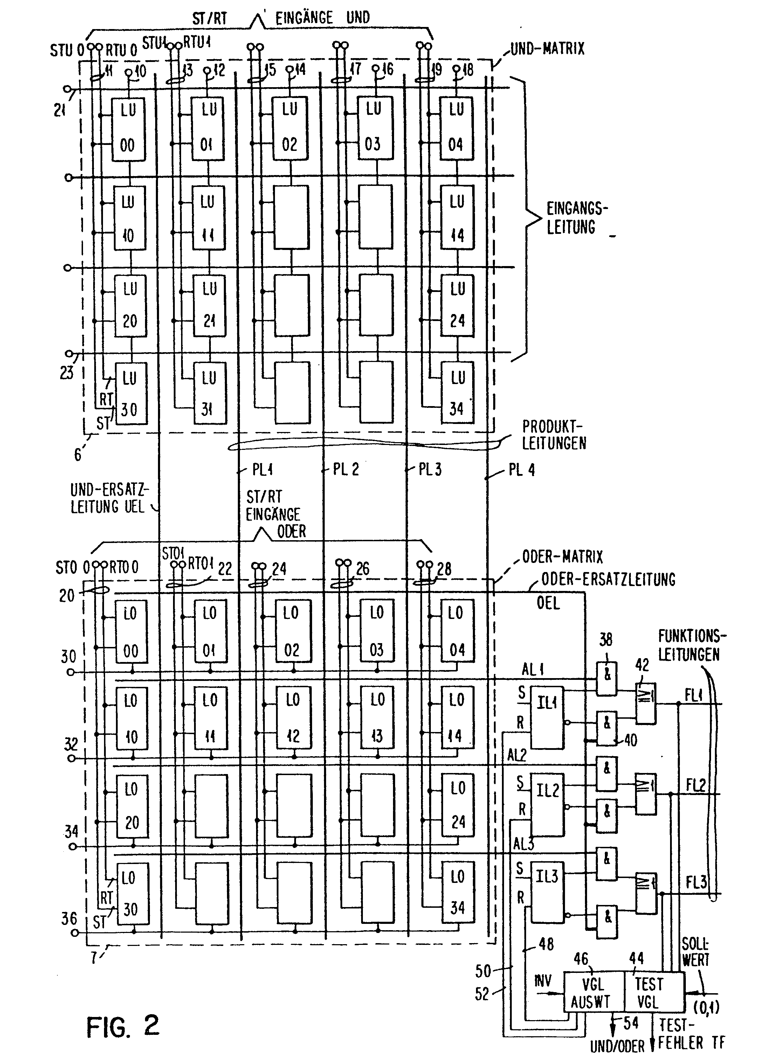

Schließlich soll noch auf den Artikel von LIPP »Array Logic« in »Second Euromicro Symposium on Microprocessing and Microprograming«, 12. bis 14. Oktober 1976, Venedig, Seiten 57 bis 64, hingewiesen werden, der in Fig. 2 die Verwendung von Speicherelementen zur Steuerung eines Kreuzungspunktes in einer PLA vorschlägt.

Die Erfindung, wie sie in den Ansprüchen gekennzeichnet ist, löst die Aufgabe, eine programmierbare logische Anordnung, deren Produktleitungen von außen nicht zugänglich sind und die Speicherelemente in den Kreuzungspunkten aufweist, so aufzubauen, daß ein automatischer Test und eine automatische Korrektur eines während des Tests festgestellten Fehlers sowie die dynamische und automatische Personalisierung in kurzer Zeit ermöglicht werden.

Die Erfindung hat den Vorteil, daß die Lokalisierung und Korrektur eines Fehlers in der PLA während des Betriebes der PLA, beispielsweise in einer Datenverarbeitungsanlage, ermöglicht wird, da das gesamte Test- und Ladeverfahren nur verhältnismäßig kurze Zeit in Anspruch nimmt. Dies wird dadurch erreicht, daß die der Verwendung von Speicherkippschaltungen in den Kreuzungspunkten inhärenten Vorteile optimal ausgenutzt werden. Durch den neuartigen Aufbau der PLA, der einerseits durch die generelle Verwendung von Speicherkippschaltungen sowohl zu den Ersatzleitungen, als auch zu den übrigen Leitungen der PLA gekennzeichnet ist, als auch durch die speziellen Setz- und Rückstelleitungen, mit Hilfe derer beispielsweise die ODER-Matrix auch spaltenweise gesetzt oder zurückgestellt werden kann, wird einerseits eine starke Verkürzung des Testverfahrens und andererseits eine genauere Lokalisierung des Fehlers erzielt. Beispielsweise ist die Lokalisierung eines einzelnen unterbrochenen Transistors durch seine genauen Koordinaten möglich. Die Vorteile der Erfindung sind insbesondere auch dann zu erzielen, wenn die die beiden Matrizen verbindenden Produktleitungen und die Speicherkippschaltungen einzeln von außen nicht zugänglich sind. Da die erfindungsgemäße Einrichtung nur jeweils kurze Zeit verwendet wird, kann sie für viele programmierbare logische Anordnungen gemeinsam vorgesehen werden. Das automatische Testen und die automatische Fehlerkorrektur machen den Einsatz von Personal zur Reparatur der Anlage unnötig. Da das Laden und Testen nur jeweils kurze Zeit benötigt, kann es jeweils vor dem Einschalten der Anlage am Morgen durchgeführt werden. Beispielsweise dauert das gesamte Test- und Ladeverfahren nur 1 msec, so daß die Datenverarbeitungsanlage nicht abgeschaltet werden muß, wenn der Fehler während des Betriebes auftritt, sondern nur eine Millisekunde angehalten wird.

Im folgenden wird die Erfindung anhand von lediglich einen Ausführungsweg darstellenden Figuren näher erläutert. Es zeigt

Fig. 1 die Verwendung einer programmierbaren logischen Anordnung (PLA) als Funktionssteuerung in einer Datenverarbeitungsanlage und die Erzeugung eines Fehlersignals,

Fig. 2 eine PLA nach der vorliegenden Erfindung,

Fig. 3 und 4 Kreuzungspunkte der Matrizen der PLA,

Fig. 5 schematisch Einrichtungen zur Erzeugung von Steuer- und Ladesignalen,

Fig. 6 Einrichtungen zum Testen und Laden der PLA unter Verwendung dieser Steuer- und Ladesignale,

Fig. 7 einen Taktimpulszug,

Fig. 8 und Fig. 9 Einzelheiten der in Fig. 6 gezeigten Einrichtungen.

Als Beispiel für die Verwendung einer programmierbaren logischen Anordnung (PLA) ist in Fig. 1 die Funktionssteuerung einer mikroprogrammierten Datenverarbeitungsanlage gezeigt. Ein Festwertspeicher 1 speichert die Mikroinstruktionen, die in ein Instruktionsregister 2 ausgelesen werden. In jeder Mikroinstruktion ist ein Paritätsbit P gespeichert, dessen Wert sich aus der Anzahl der zu aktivierenden Funktionsleitungen ergibt und welches ebenfalls in das Register 2 ausgelesen wird. Die codierten Operationssignale der Mikroinstruktion werden den Eingangsleitungen der PLA 3 zugeführt. Am Ausgang der Anordnung 3 sind Funktionsleitungen vorgesehen, die mit bestimmten Steuereingängen in der Datenverarbeitungsanlage verbunden sind. Je nach Mikroinstruktion werden auf ganz bestimmten Funktionsleitungen Signale erhalten, welche in hier nicht gezeigter Weise zur Steuerung der Anlage verwendet werden. Die Funktionsleitungen sind mit den Eingängen einer Paritätsschaltung 4 verbunden, welche aus den erhaltenen binären 1-Werten ein weiteres Paritätsbit erzeugt, das im EXCLUSIV-ODER-GLIED 5 mit dem Paritätsbit in der betreffenden Mikroinstruktion verglichen wird. Im Normalfall stimmen beide Bits überein. Ist dies nicht der Fall, wird am Ausgang des EXCLUSIV-ODER-GLIEDES 5 ein Fehlersignal CH erzeugt, welches in der überwiegenden Mehrzahl der Fälle auf eine fehlerhafte Arbeitsweise der programmierbaren logischen Anordnung 3 hinweist, da die übrigen Einrichtungen zumeist weitaus fehlersicherer aufgebaut sind und auch auf andere Weise überprüft werden können. Mit der in Fig. 1 gezeigten Einrichtung ist also die PLA 3 auf fehlerfreie Arbeitsweise überprüfbar.

Der Aufbau einer programmierbaren logischen Anordnung nach der vorliegenden Erfindung ist in Fig. 2 näher gezeigt. Die gezeigte PLA weist eine Anzahl von Eingangsleitungen auf, die zugleich die Zeilen einer UND-Matrix 6 bilden. Die Ausgangsleitungen der Matrix 6, welche den Spalten der Matrix entsprechen, werden Produktleitungen genannt. An jedem Kreuzungspunkt der UND-Matrix ist beispielsweise ein Transistor T vorgesehen, wie weiter unten anhand der Fig. 3 und 4 gezeigt wird. Entlang den Spalten der Matrix sind Schieberegister angeordnet, die ebensoviel Stufen aufweisen wie Eingangsleitungen vorhanden sind. Jede Stufe steuert dabei den ihr zugeordneten Transistor. Durch das in den Schieberegistern gespeicherte Muster ist somit der logische Zustand der UND-Matrix definiert. Für jedes Schieberegister ist eine Steuerleitung STU/RTU vorgesehen, über welche alle Stufen des Schieberegisters entweder gesetzt (ST) oder zurückgestellt (RT) werden können. Fig. 2 zeigt ganz oben die Eingänge zu diesen für alle Stufen eines Schieberegisters gemeinsamen Steuerleitungen. Die Eingänge zu den jeweiligen Schieberegistern sind in Fig. 2 mit 10, 12, 14, 16 und 18 bezeichnet. Wenn die am meisten links liegende Spalte der UND-Matrix 6 als nullte Spalte, und wenn die oberste Zeile der Matrix als nullte Zeile bezeichnet wird, so können die in Form einer Matrix angeordneten Stufen der einzelnen Schieberegister entsprechend den Indizes für Zeile (n) und Spalte (p) mit LU np bezeichnet werden. Das zur nullten Spalte gehörige Schieberegister enthält demnach die Stufen LU 00 bis LU 30.

Die den Spalten 1 bis 4 entsprechenden Ausgangsleitungen der UND-Matrix 6 werden als Produktleitungen PL1 bis PL4 bezeichnet. Diese Leitungen bilden die Eingänge einer ODER-Matrix 7, auf deren Ausgangsleitungen AL1, AL2 und AL3 die Ausgangssignale der PLA erhalten werden. Auch in den Kreuzungspunkten der ODER-Matrix 7 sind analog zur Matrix 6 Transistoren vorgesehen, welche ebenso wie in der Matrix 6 von Stufen von Schieberegistern gesteuert werden. Im Gegensatz zur UND-Matrix 6 sind die Schieberegister der ODER-Matrix 7 jedoch entlang den Zeilen angeordnet. Das der nullten Zeile der ODER-Matrix 7 zugeordnete Schieberegister weist demnach die Stufen LO 00 bis LO 04 auf. Das Eingangssignal zu diesem Schieberegister wird am Anschluß 30 zugeführt. Die den weiteren Zeilen 1 bis 3 der ODER-Matrix 7 zugeordneten Schieberegister können an den Anschlüssen 32 bis 36 geladen werden. Die zu einer bestimmten Spalte der ODER-Matrix 7 gehörigen Schieberegisterstufen können durch eine gemeinsame Leitung STO/RTO entweder gesetzt (ST) oder zurückgestellt (RT) werden (Leitungen 20, 22, 24, 26, 28). Abweichend von der UND-Matrix 6 werden also in der ODER-Matrix 7 nicht jeweils alle Stufen eines bestimmten Schieberegisters, sondern alle Stufen derselben Rangordnung aller Schieberegister zugleich entweder gesetzt oder zurückgestellt.

Erfindungsgemäß ist zusätzlich zu den Produktleitungen PL1 bis PL4 noch eine UND-Ersatzleitung UEL vorgesehen, welche die nullte Spalte der Matrizen 6 und 7 bildet. Ferner ist erfindungsgemäß zusätzlich zu den zeilenförmig angeordneten Ausgangsleitungen AL1 bis AL3 der ODER-Matrix 7 noch eine der nullten Zeile der Matrix 7 zugeordnete ODER-Ersatzleitung OEL vorgesehen. Die beiden Ersatzleitungen haben den Zweck, bei Auftreten eines Einzelfehlers in der PLA die betroffenen Kreuzungspunkte ausschalten und durch Ersatzkreuzungspunkte ersetzen zu können. Die am Ausgang der ODER-Matrix 7 angeordnete logische Einrichtung, welche weiter unten näher beschrieben wird, gestattet es, eine der Ausgangsleitungen AL1 bis AL3 durch die Ersatzleitung OEL zu ersetzen, indem die betroffene Kippschaltung IL1 bis IL3 zurückgestellt wird, wodurch beispielsweise für die Ausgangsleitung AL1 das UND-Glied 38 aus- und das UND-Glied 40 eingeschaltet wird. Über das ODER-Glied 42 wird demnach auf der Funktionsleitung FL1 ein Signal erhalten, das dem Signal auf der Ersatzleitung OEL entspricht. Die Kippschaltungen IL1 bis IL3 werden beim Laden der PLA alle gesetzt. Die Funktionsleitungen FL1 bis FL3 entsprechen sinngemäß den in Fig. 1 am Ausgang der PLA 3 gezeigten Funktionsleitungen.

In einer PLA der in Fig. 2 gezeigten Art können vier verschiedene Typen von Fehlern unterschieden werden: Der Transistor eines Kreuzungspunktes kann entweder nicht mehr ein- oder ausgeschaltet werden, und eine Leitung ist entweder unterbrochen oder weist einen Kurzschluß auf. Im folgenden werden diese Zustände damit bezeichnet, daß der betreffende Transistor oder die betreffende Leitung auf »0« oder »1« »eingerastet« ist.

Um die Art der auftretenden Fehler und das Testverfahren zur Ermittlung dieser Fehler besser erklären zu können, sollen nun zwei mögliche Implementierungen der Kreuzungspunkte der UND-Matrix 6 und der ODER-Matrix 7 beschrieben werden.

Fig. 3A zeigt einen Kreuzungspunkt für die UND-Matrix 6, der eine Kippschaltung LU (Bezugszeichen 56), ein logisches Glied 58 und einen Transistor T aufweist. Mit Hilfe der zu einer bestimmten Spalte gehörenden Kreuzungspunkte in der Matrix 6 soll jeweils eine UND-Bedingung für bestimmte Eingangsleitungen realisiert werden. Soll beispielsweise auf der Produktleitung PL4 ein Signal erhalten werden, wenn sowohl auf der Eingangsleitung 21 als auch auf der Eingangsleitung 23 ein Signal anliegt, so müssen in der betreffenden Spalte die beiden Kippschaltungen LU 04 und LU 34 gesetzt werden. Die UND-Funktion wird dadurch erhalten, daß sowohl der von der Kippschaltung LU 04 als auch der von der Kippschaltung LU 34 gesteuerte Transistor nichtleitend wird, wodurch die Produktleitung PL4 Pluspotential annimmt. Dies ist jedoch nur möglich, wenn alle restlichen Transistoren zu dieser Spalte bereits den nichtleitenden Zustand eingenommen haben. Wäre nämlich einer der restlichen Transistoren leitend, so könnte die Produktleitung PL4 niemals Pluspotential annehmen. Hieraus ergeben sich die in Fig. 3C gezeigten Bedingungen für die logischen Signale an der Eingangsleitung sowie den logischen Zustand der Kippschaltung LU. Die Transistoren T müssen also auf jeden Fall offen sein, wenn die Kippschaltung nicht gesetzt ist (erste und dritte Zeile). Ist die Kippschaltung jedoch gesetzt, so muß der Transistor T leitend werden, wenn am Eingang eine binäre Null anliegt und wird der Transistor geöffnet, wenn am Eingang eine binäre Eins anliegt (zweite bzw. vierte Zeile der Fig. 3C). Ist nun entweder der Transistor T oder die Leitung PL eingerastet, so ergeben sich entsprechend der in Fig. 3C gezeigten Tabelle die in Fig. 3B gezeigten Zustände.

Die in Fig. 3C gezeigten logischen Bedingungen sind z. B. mit der in Fig. 3A gezeigten Schaltung eines Kreuzungspunktes zu verwirklichen. In dieser Schaltung ist der Kollektor eines npn-Transistors T mit der Produktleitung PL und der Emitter dieses Transistors mit Masse (GND) verbunden. Die Eingangsleitung wird mit einem invertierenden Eingang eines UND-Gliedes 58 und der andere Eingang dieses UND-Gliedes mit dem wahren Ausgang Q der Kippschaltung LU 56 verbunden. Der Ausgang des UND-Gliedes 58 steuert die Basis des Transistors T an. Sind beide Eingangsbedingungen des UND-Gliedes 58 erfüllt, geht der Ausgang hoch, d. h. wird positiver, und öffnet den Transistor T.

In Fig. 4A ist eine mögliche Realisierung für einen Kreuzungspunkt der ODER-Matrix 7 gezeigt. Die ODER-Funktion wird hier dadurch erfüllt, daß einer der an eine bestimmte Ausgangsleitung AL angeschlossenen Transistoren T leitend wird. Der Einszustand der Ausgangsleitung AL ist also durch das Nullpotential (GND) gegeben (während der binäre 1-Wert einer Produktleitung PL durch das Pluspotential gegeben ist!). Die logischen Bedingungen für einen Kreuzungspunkt der ODER-Matrix 7 sind in Fig. 4C gegeben. Demnach muß der Transistor T leitend werden, wenn die Kippschaltung LO gesetzt ist und auf der Produktleitung PL ein 1-Wert ankommt. Ist die Kippschaltung nicht gesetzt (Zeilen 1 und 3 in Fig. 4C), muß der Transistor offen bleiben, da nur so gewährleistet ist, daß die zu gesetzten Kippschaltungen gehörenden Transistoren T die ODER-Funktion realisieren können. Entsprechend den angegebenen Potentialverhältnissen ergibt sich die in Fig. 4B gezeichnete Tabelle für fehlerhafte Ausgangsleitungen AL oder fehlerhafte Transistoren T.

Erfindungsgemäß wird bei Auftreten eines Signals, das einen Fehler in der PLA anzeigt, wie z. B. das Signal CH in Fig. 1, ein Testverfahren eingeleitet, das es gestattet, den fehlerhaften Transistor, oder die fehlerhafte Leitung zu identifizieren und mit Hilfe der Ersatzleitung UEL oder der Ersatzleitung OEL die PLA wieder betriebsfähig zu machen.

Das nachfolgend beschriebene Testverfahren bezieht sich auf eine PLA mit n-Eingangsleitungen zur UND-Matrix, mit p-Spalten und m-Ausgangsleitungen der ODER-Matrix. Die Spalten enthalten dabei eine Ersatzleitung UEL und p−1 Produktleitungen. Die Ausgangsleitungen der ODER-Matrix enthalten eine ODER-Ersatzleitung OEL und m−1 Funktionsleitungen. In dem in Fig. 2 gezeigten Beispiel sind vier Eingangsleitungen, fünf Spalten und vier Ausgangsleitungen vorgesehen. Die entsprechenden Numerierungen laufen also jeweils von 0 bis n−1, von 0 bis p−1 und von 0 bis m−1.

Tabelle I

| Phase | Schritt | Eingangs-leitungen | UND-Matrix Sp. 0 1 ... p−1 | ODER-Matrix Sp. 0 1 ... p−1 | FEHLER Typ L, T | Matrix | einge-rastet | AUSGANGS-Signal der Funkt.ltg. mit Fehl. | ohne Fehl. |
|---|---|---|---|---|---|---|---|---|---|
| 1 | S1 | X | ganz rückstellen | ganz rückstellen | L, T | ODER | 1 | 0 . . 0 1 0 . . 0 | 0 . . . . . 0 |
| 2 | S2 | X | ganz rückstellen | ganz setzen | L | ODER | 0 | 1 . . 1 0 1 . . 0 | 1 . . . . . 1 |
| 3 | 0 | X | ganz rückstellen | st  rt . . . . . rt | L, T | UND | 0 | 0 . . . . . . 0 | 1 . . . . 1 |
|  | 1 |  |  | rt  st . . . . . rt | T | ODER | 0 | 1 . . 1 0 1 . . 1 | 1 . . . . 1 |
|  | . |  |  | .   . |  |  |  |  |  |
|  | . |  |  | . |  |  |  |  |  |
|  | p−1 |  |  | rt  rt . . . . . st |  |  |  |  |  |
| 4 | p | 0 | st  rt . . . . . rt | st  rt . . . . . rt | L | UND | 1 | 1 . . . . . . 1 | 0 . . . . 0 |
|  | p+1 |  | rt  st . . . . . rt | rt  st . . . . . . |  |  |  |  |  |
|  | . |  | .      . | .      . |  |  |  |  |  |
|  | . |  | .      . | .      . |  |  |  |  |  |
|  | . |  | .      . | .      . |  |  |  |  |  |
|  | 2p−1 |  | rt . . . . . . . . st | rt . . . . . . . . st |  |  |  |  |  |

Tabelle II — Alle Eingangsleitungen auf 0

| Phase | Schritt | UND-Matrix Sp. 0 1 ... p−1 | ODER-Matrix Sp. 0 1 ... p−1 | Fehler T UND einger. auf 1 | Kein Fehler |
|---|---|---|---|---|---|
| 5 | 2p | st    rt ... rt<br>rt    ·<br>·<br>rt    · | st  rt ... rt | 1 ............ 1 | 0 ....... 0 |
|  | 2p+1 | rt ......... rt<br>st    ·<br>rt    ·<br>·    ·<br>rt ......... rt |  |  |  |
|  | · |  |  |  |  |
|  | 2p+n−1 | rt ......... rt<br>·    ·<br>rt    ·<br>st    rt ... rt |  |  |  |
| 6 | 2p+n | rt  st  rt ... rt<br>·  rt  ·<br>·  ·  ·<br>rt  rt ...... rt | rt  st  rt ... rt | 1 ............ 1 | 0 ....... 0 |
|  | · |  |  |  |  |
|  | 2p+2n−1 | rt    rt ... rt<br>·  ·  ·<br>·  rt  ·<br>rt  st  rt ... rt |  |  |  |
| ·<br>· | ·<br>· | ·<br>· | ·<br>· | 1 ............ 1 | 0 ....... 0 |
| 5+p−1 | 2p+n(p−1) | rt ..... rt    st<br>·    rt<br>·    ·<br>rt ......... rt | rt  rt ... rt  st | 1 ............ 1 | 0 ....... 0 |
|  | · |  |  |  |  |
|  | 2p+n·p−1 | rt ......... rt<br>·    ·<br>·    rt<br>rt ..... rt  st |  |  |  |

Das in den Tabellen I und II (Seiten 13 und 14) gezeigte Testverfahren kann sowohl bei der Produktion der PLA als auch während des Betriebes der PLA in einer Datenverarbeitungsanlage ausgeführt werden. Das Testverfahren ist in den Tabellen der besseren Übersicht wegen in einzelne Phasen unterteilt. Außer den ersten beiden Phasen 1 und 2 weist jede Phase eine Mehrzahl von Schritten auf. Die erste Spalte der Tabellen (ganz links) gibt die Phase an und die zweite Spalte die Schritte. Die restlichen Spalten der Tabelle I zeigen die Zustände der Eingangsleitungen, der einzelnen Spalten der UND-Matrix sowie der ODER-Matrix. Die nächste Spalte enthält Angaben über die Art des auftretenden Fehlers, während die letzte, zweigeteilte Spalte angibt, welche Signale auf den Funktionsleitungen erwartet werden, wenn die PLA einen bzw. keinen Fehler aufweist. Das Setzen und Zurückstellen einer Matrix bezieht sich natürlich auf die Kippschaltungen dieser Matrix.

Im Schritt S1 spielen die Signale auf den Eingangsleitungen keine Rolle (Zeichen X). Die gesamte UND-Matrix wird über die Leitungen RTU zurückgestellt, d. h. alle Transistoren T sind gesperrt und alle Leitungen PL sind auf Pluspotential. Auch die ODER-Matrix wird ganz über die Leitungen RTO zurückgestellt, d. h. auch dort sind alle Transistoren T gesperrt und alle Ausgangsleitungen AL auf Pluspotential, das dort jedoch dem binären 0-Wert entspricht. Auf allen Funktionsleitungen FL1 bis FL3 in Fig. 2 wird also ein 0-Signal erwartet. Hat eines dieser Signale jedoch den 1-Wert, so weist die zugehörige Ausgangsleitung AL einen Kurzschluß mit Masse auf, liegt also auf dem binären 1-Wert. Dasselbe Fehlersignal wird jedoch auch dann erhalten, wenn einer der zu dieser Ausgangsleitung gehörenden Transistoren T einen Kurzschluß mit Masse aufweist. Im Schritt S1 wird also festgestellt, ob entweder eine Ausgangsleitung AL oder ein mit dieser Ausgangsleitung verbundener Transistor einen Kurzschluß mit Masse aufweist. In den Testvergleicher 44 (Fig. 2) wird im Schritt S1 der Soll-Wert 0 für alle Leitungen eingegeben. Der Vergleicher 44 vergleicht das Signal auf jeder der Leitungen FL mit dem Soll-Wert. Wird eine Nichtübereinstimmung zwischen diesem Soll-Wert und einem Ist-Wert auf einer der Funktionsleitungen FL festgestellt, so zeigt der Ausgang des Testvergleichers 44 einen Testfehler TF an. Die betreffende Ausgangsleitung wird direkt vom Vergleichsauswerter 46 angezeigt, indem eine der Leitungen 48, 50 oder 52, die jeweils einer Funktionsleitung zugeordnet sind, den binären 1-Wert führt. Das Signal INV (siehe weiter unten) ist im Schritt S1 nicht eingeschaltet. Das entsprechende 1-Signal auf einer der Leitungen 48 bis 52 stellt die betreffende Kippschaltung IL zurück, wodurch die ODER-Ersatzleitung OEL anstelle der betreffenden Ausgangsleitung AL zur Funktionsleitung FL durchgeschaltet wird. Die fehlerhafte Zeile der ODER-Matrix 7 wird auf diese Weise ausgeschaltet und anstelle der fehlerhaften Leitung wird die Ersatzleitung OEL eingeschaltet, welche natürlich noch mit den zu der fehlerhaften Ausgangsleitung AL gehörenden Daten geladen werden muß. Dies wird weiter unten noch beschrieben werden.

In der Phase 2, d. h. im Schritt S2, müssen die folgenden Bedingungen geschaffen werden: Der Zustand der Eingangsleitungen spielt keine Rolle, die UND-Matrix wird ganz zurückgestellt und die ODER-Matrix wird ganz gesetzt. Wie im Schritt S1 führen somit alle Produktleitungen Pluspotential. Hierdurch und da die ganze ODER-Matrix gesetzt ist, sind alle Transistoren T in der ODER-Matrix leitend und somit müssen alle Ausgangsleitungen auf Nullpotential liegen, d. h. den binären Wert 1 ergeben. Der in den Testvergleicher 44 einzugebende Soll-Wert besteht also für jede Funktionsleitung FL aus dem 1-Wert. Stellt jedoch der Testvergleicher 44 fest, daß eine der Funktionsleitungen FL den 0-Wert führt, so wird hierdurch angezeigt, daß die betreffende Ausgangsleitung AL fehlerhaft ist. Am Eingang des Vergleichsauswerters 46 liegt das Signal INV an, so daß der einzelne, den Fehler anzeigende 0-Wert zu einem binären 1-Wert invertiert wird und, wie vorher beschrieben, die betreffende Kippschaltung IL zurückstellt. Diese Kippschaltungen IL müssen natürlich jeweils vor Inbetriebnahme der PLA gesetzt werden. Die fehlerhafte Ausgangsleitung AL, die auf 0 eingerastet ist und somit positives Potential aufweist, wird durch die Ersatzleitung OEL ersetzt.

Es folgt nun die Phase 3, während der festgestellt werden soll, ob eine Leitung oder ein Transistor der UND-Matrix auf 0 eingerastet ist, was sich dadurch äußert, daß die betreffende Produktleitung PL auf Nullpotential liegt. Auch in der Phase 3 spielt der logische Zustand der Eingangsleitungen keine Rolle. Die UND-Matrix wird ganz zurückgestellt, d. h. alle Produktleitungen PL sollen Pluspotential führen. Im Gegensatz zu den beiden vorhergehenden einschrittigen Phasen weist die Phase 3 ebensoviel Schritte auf, wie Spaltenleitungen vorhanden sind. Sind p-Spalten vorhanden, so wird die erste Spalte, d. h. die Ersatzleitungsspalte mit 0 bezeichnet und die letzte Spalte, das ist die zur Produktleitung PL4 in Fig. 2 gehörende Spalte mit p−1. Aus der Tabelle I ist zu ersehen, daß im Beginnschritt der Phase 3, das ist im Schritt 0, die Spalte 0 der ODER-Matrix über die Leitung STUO gesetzt ist, während alle anderen Spalten zurückgestellt sind. Liegt also, wie im fehlerfreien Fall erwartet werden muß, die Leitung UEL auf Pluspotential, d. h. führt sie den binären Wert 1, so müssen alle Funktionsleitungen auf 1 sein, da ja die erste Spalte der ODER-Matrix 7 gesetzt ist. Der in den Testvergleicher einzugebende Soll-Wert ist also der 1-Wert. Ist jedoch die Leitung UEL, die ja zur nullten Spalte gehört, auf 0 eingerastet, d. h. hat sie einen Kurzschluß mit Masse, so kann keine der Ausgangsleitungen ein Signal, d. h. Nullpotential führen und es wird das in der Tabelle I zur Phase 3 angegebene Fehlersignal (lauter Nullen) erhalten. Dasselbe Fehlersignal wird jedoch auch dann erhalten, wenn einer der mit dieser Spaltenleitung verbundenen Transistoren T (Fig. 3A) einen Kurzschluß mit Masse aufweist, da ja auch ein solcher kurzgeschlossener Transistor die betreffende Spaltenleitung auf Nullpotential zieht. Im Schritt 1 wird die zur ersten Spalte (PL1, Fig. 2) gehörende Spaltenleitung auf Kurzschluß mit Masse dadurch geprüft, daß in der ODER-Matrix die zu dieser Spalte gehörenden Kippschaltungen LO 01, LO 11, usw. über die Leitung STO1 gesetzt werden, während alle anderen Spalten der ODER-Matrix zurückgestellt sind. In den weiteren Schritten 2 bis p−1 werden die restlichen Spaltenleitungen geprüft.

In der Phase 3 kann jedoch mit denselben logischen Zuständen der UND-Matrix und der ODER-Matrix festgestellt werden, ob ein Transistor der betreffenden gesetzten Spalte in der ODER-Matrix auf 0 eingerastet ist, d. h. unterbrochen ist. Da ein solcher Transistor auch durch das Setzsignal der zugehörigen Kippschaltung LO nicht leitend gemacht werden kann, erscheint auf der betreffenden Funktionsleitung ein 0-Signal, das vom Testvergleicher 44 erkannt wird. Vom Auswerter 46 wird nach Invertierung dieses einzelnen 0-Signals in eine binäre 1 die betreffende Ausgangsleitung AL, in der sich der schadhafte Transistor befindet, unwirksam geschaltet.

In der Phase 4 soll geprüft werden, ob eine Spaltenleitung auf 1 eingerastet ist, d. h. immer Pluspotential führt. Hierzu wird an alle Eingangsleitungen ein 0-Signal angelegt und wird jeweils eine Spalte der UND-Matrix sowie die entsprechende Spalte der ODER-Matrix gesetzt. Beispielsweise werden im Schritt p die Spalte 0 der UND-Matrix und die Spalte 0 der ODER-Matrix gesetzt. Da an allen Eingangsleitungen ein 0-Signal anliegt, werden alle Transistoren der Spalte 0 der UND-Matrix 6 leitend gemacht (Zeile 2 in Fig. 3C) und liegt die Spaltenleitung UEL auf Masse, hat also den binären 0-Wert. Da in der ODER-Matrix alle Kippschaltungen zu dieser Spalte gesetzt sind, sind alle Transistoren dieser Spalte offen und liegen alle Ausgangsleitungen AL der ODER-Matrix auf Pluspotential (0-Wert, siehe zweite Zeile in Fig. 4C). Ist jedoch die betreffende Spaltenleitung auf 1 eingerastet, d. h. liegt sie auf Pluspotential und führt somit den binären 1-Wert, so wird auf allen Funktionsleitungen FL ein 1-Signal erhalten und der Vergleicher 44 zeigt einen Testfehler an.

Mit dem erfindungsgemäßen Testverfahren kann jedoch auch noch festgestellt werden, ob ein einzelner Transistor in der UND-Matrix 6 auf 1 eingerastet ist, d. h. unterbrochen ist. Während also ein kurzgeschlossener Transistor nicht identifizierbar ist, da auch eine kurzgeschlossene Leitung dasselbe Fehlersignal verursacht, ist ein unterbrochener Transistor sowohl in der UND-Matrix als auch in der ODER-Matrix sehr wohl einzeln feststellbar, da die mit einem solchen unterbrochenen Transistor verbundene Leitung noch durch andere mit dieser Leitung verbundene Transistoren beeinflußbar ist. In den nachfolgenden Phasen 5 bis 5+p−1 wird jeweils nur eine einzelne Kippschaltung LU in der UND-Matrix gesetzt, während alle anderen Kippschaltungen zurückgestellt bleiben. Dabei wandert der Setzzustand von der obersten Kippschaltung einer Spalte in n-Schritten bis zur untersten Kippschaltung, da n-Eingangsleitungen vorgesehen sind. Nach solchen n-Schritten wird zur darauffolgenden Spalte übergegangen und ebenfalls der Setzzustand von der ersten bis zur letzten Kippschaltung der betreffenden Spalte durchgeschoben. Bei einem solchen Durchschieben bzw. Durchwandern des Setzzustandes einer einzelnen Kippschaltung durch eine bestimmte Spalte wird die entsprechende Spalte in der ODER-Matrix gesetzt, während alle anderen Spalten in der ODER-Matrix zurückgestellt werden. Wie aus der Tabelle II ersichtlich ist, ist der erste Schritt der Phase 5 mit 2p bezeichnet. Dies ergibt sich aus der Durchnumerierung der Schritte ab Beginn der Phase 3, da die beiden Phasen 3 und 4 jeweils p-Schritte umfassen. Im Schritt 2p wird also die oberste Kippschaltung der nullten Spalte, das ist die Kippschaltung LU 00, gesetzt, während die gesamte restliche UND-Matrix zurückgestellt wird. In der ODER-Matrix 7 ist die erste Spalte gesetzt, während alle anderen Spalten zurückgestellt sind. Während des gesamten Testverfahrens nach Tabelle II liegen an allen Eingängen der PLA 0-Signale an. Der zu der Kippschaltung LU 00 gehörende Transistor ist also im Schritt 2p leitend (Zeile 2 in Fig. 3C) und die nullte Spaltenleitung UEL liegt auf Nullpotential. Hierdurch wird keiner der Transistoren der nullten Spalte in der ODER-Matrix leitend geschaltet. Da die zu allen anderen Spalten der ODER-Matrix gehörenden Kippschaltungen LO zurückgestellt sind, sind auch alle restlichen Transistoren der ODER-Matrix offen, so daß am Ausgang der ODER-Matrix lauter binäre 0-Werte erhalten werden (letzte Spalte der Tabelle II).

Ist jedoch der zu der betreffenden gesetzten Kippschaltung LU 00 gehörende Transistor T unterbrochen, d. h. ist er im binären 1-Zustand eingerastet, so wird die Spaltenleitung UEL nicht auf Nullpotential gebracht und werden alle Ausgangsleitungen der ODER-Matrix auf den binären 1-Wert gebracht, da ja alle nur nullten Spalte gehörenden Kippschaltungen der ODER-Matrix gesetzt sind. Werden also am Ausgang der PLA lauter Einsen erhalten (vorletzte Spalte), so zeigt dies an, daß der betreffende gesetzte Transistor in der UND-Matrix schadhaft ist. Er ist auf 1 eingerastet, d. h. unterbrochen.

In den folgenden Schritten 2p+1 bis 2p+n−1 wandert der Setzzustand der einzelnen gesetzten Kippschaltung LU durch alle n-Zeilen der nullten Spalte, wobei nach jeder Fortschaltung des 1-Zustandes am Ausgang der PLA vom Testvergleicher 44 ein Vergleich mit dem Soll-Wert »lauter Nullen« durchgeführt wird. Nachdem somit alle Transistoren der nullten Spalte der UND-Matrix 6 geprüft sind, wird die erste Kippschaltung LU 01 der ersten Spalte gesetzt und nachfolgend die erste Spalte in gleicher Weise wie die nullte Spalte geprüft. Der am Ausgang der PLA erwartete Soll-Wert sowie der bei einem Fehler auftretende Wert auf den Funktionsleitungen bleibt für die gesamte Tabelle II der gleiche. Nach Prüfung der ersten Spalte der PLA erfolgt in der Phase 6 die Prüfung der zweiten Spalte. Die Prüfung auf einen auf 1 eingerasteten Transistor in der UND-Matrix erfordert also so viele Phasen, wie Spalten vorgesehen sind, d. h. p-Phasen. In jeder Phase wird während eines Testschrittes jeweils die zu einer Zeile gehörende Kippschaltung gesetzt, so daß so viele Schritte innerhalb einer Phase nötig sind, wie Zeilen vorgesehen sind, d. h. n-Schritte. Das gesamte Verfahren nach Tabelle II erfordert also n · p-Schritte, so daß der letzte Schritt mit 2p+np−1 und die letzte Phase mit 5+p−1 zu bezeichnen ist. Um einen einzelnen auf 1 eingerasteten Transistor in der UND-Matrix feststellen zu können, sind also unverhältnismäßig viele Testschritte erforderlich. Man wird daher diesen Teil des Testverfahrens nach Tabelle II beispielsweise nur nach der Produktion der PLA durchführen, wenn beispielsweise eine fehlerhafte Funktionsweise der Produktionseinrichtungen festgestellt werden soll. Während des Betriebes der PLA reicht zumeist die Phase 4 aus, da der darin festgestellte Fehler auch einen auf 1 eingestellten Transistor der UND-Matrix mit einschließt (vergleiche Soll-Wert und Fehlersignal).

Das vorstehend beschriebene Testverfahren ist auf die in den Fig. 3 und 4 gezeigten Realisierungen von Kreuzungspunkten ausgerichtet. Werden jedoch andere Realisierungen gewählt, kann es unter Umständen vorteilhaft sein, bestimmte Spalten in den Matrizen rückstellen zu können, während alle anderen Spalten gesetzt bleiben. Ebenso kann es vorteilhaft sein, einen binären 0-Zustand durch alle Kippschaltungen durchwandern zu lassen, während alle anderen Kippschaltungen gesetzt sind. Je nach verwendetem Kreuzungspunkt können also unter Umständen einzelne der im Zusammenhang mit den Tabellen I und II beschriebenen Phasen überflüssig sein, während zusätzlich Phasen der erwähnten Art durchgeführt werden müssen. Prinzipiell ergeben sich also die maximalen Möglichkeiten, wenn jede der beiden Matrizen sowohl ganz gesetzt als auch ganz zurückgestellt werden kann, wenn jeweils ganze Spalten sowohl gesetzt als auch zurückgestellt werden können und wenn einzelne Kippschaltungen sowohl gesetzt als auch zurückgestellt werden können. Außerdem erscheint es sinnvoll, zuerst die Leitungen der PLA zu überprüfen und hierauf einzelne Transistoren, wobei in der Reihenfolge zuerst die ODER-Matrix 7 und dann die UND-Matrix 6 zu prüfen ist. Da ferner ab Phase 4 alle Eingangsleitungen auf 0 sein müssen, ist es vorteilhaft, auch in den ersten drei Phasen 0-Signale an den Eingängen zuzuführen.

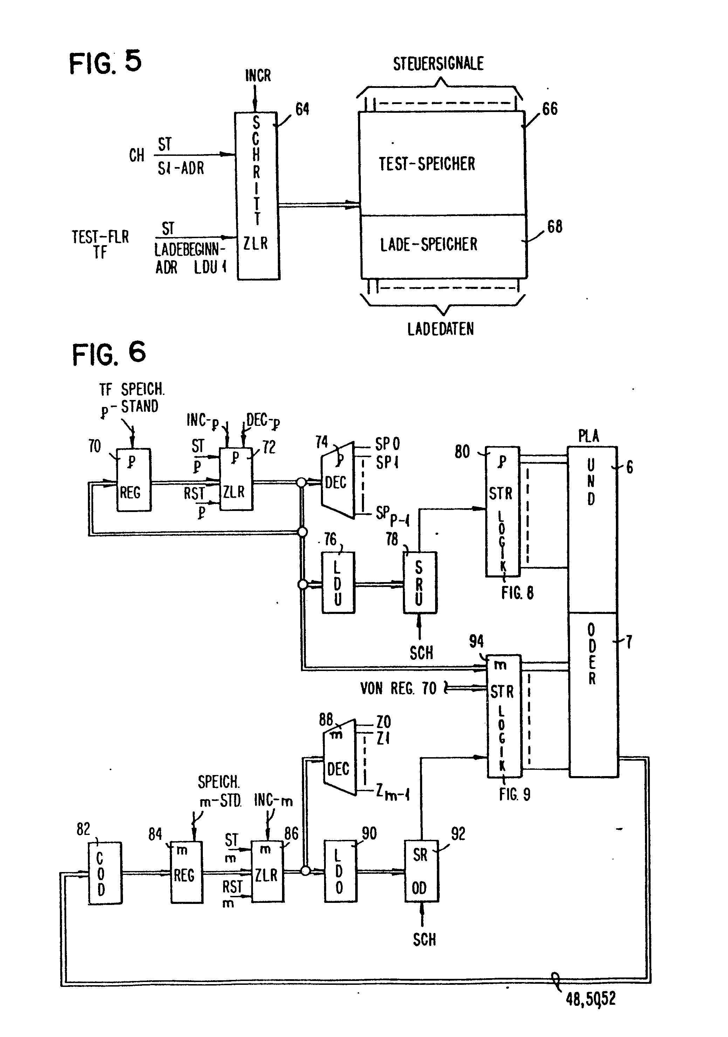

Wie bereits erwähnt, wird beim Auftreten eines Fehlersignals CH (Fig. 1) die Datenverarbeitung kurz angehalten und das beschriebene Testverfahren gestartet. Da durch das Testverfahren die in den Kippschaltungen der PLA gespeicherten Daten zerstört werden, ist nach Abschluß des Testverfahrens ein Wiederladen der PLA notwendig. In Fig. 5 ist schematisch gezeigt, mit welchen Einrichtungen das Testverfahren und das anschließende Ladeverfahren durchgeführt werden. Zur Definierung der Schritte des Testverfahrens und des Ladeverfahrens ist ein Schrittzähler 64 vorgesehen, der beim Auftreten eines Fehlersignals CH in Gang gesetzt wird. Hierzu wird der Zähler 64 auf den Stand gebracht, der für den Schritt S1 (Tabelle I) vorgesehen ist. Die Ausgangssignale des Zählers 64 adressieren einen Testspeicher 66 und einen Ladespeicher 68, die als Festwertspeicher ausgeführt sein können. Während des Testverfahrens wird bei jedem Testschritt ein Wort aus dem Testspeicher ausgelesen, dessen einzelne Bits die Steuersignale zur Durchführung des Testverfahrens darstellen. Tritt während des Testverfahrens ein Fehler auf, so wird der Schrittzähler 64 angehalten und sein Stand abgespeichert. Mit Hilfe dieses Standes und der hierdurch vom Testspeicher 66 erhaltenen Steuersignale kann automatisch der aufgetretene Fehler bestimmt werden. Hierauf wird durch das Testfehlersignal in den Schrittzähler 64 die Beginnadresse des Ladevorganges geladen. Während des Ladevorganges werden vom Ladespeicher 68 die Daten erhalten, welche in die Verriegelungsschaltungen der PLA eingespeichert werden sollen. Während des Ladevorganges werden am Ausgang des Testspeichers 66 Steuersignale erhalten, welche zur Durchführung des Ladevorganges benötigt werden.

Wird das Testverfahren nicht durch einen Fehler eingeleitet, sondern beispielsweise vor der Inbetriebnahme der PLA durchgeführt, so wird das Ladeverfahren im Anschluß an den letzten Schritt des Testverfahrens durchgeführt.

Die zur Durchführung des Testverfahrens maximal nötige Zeit ergibt sich aus der Zahl der nötigen Schritte multipliziert mit der Schrittzeit. Nach der Tabelle I sind (2+2p) Schritte und nach der Tabelle II n · p Schritte nötig, insgesamt also (2+2p+np) Schritte. Bei einer Dauer von 20 nsec pro Schritt und bei praktischen Werten von p=200 und n=100, dauert das Testverfahren also 408 040 nsec, d. h. ca. 0,4 Millisekunden. Werden nur die Schritte nach Tabelle I ausgeführt, ergibt sich eine Dauer von nur 402 · 20 nsec, als ca. 8 Mikrosekunden.

Die zur Durchführung der Verfahren notwendigen Steuersignale und Einrichtungen sollen nun anhand der Tabellen III und IV sowie anhand der Fig. 6 näher erläutert werden.

Zur Durchführung des Testverfahrens werden die folgenden Steuersignale verwendet:

— TEST:
Dieses Signal ist während des ganzen Testverfahrens an. Seine Bedeutung wird weiter unten noch beschrieben.

— INV:
Dieses Signal wird an den Vergleichsauswerter 46 (Fig. 2) angelegt und gibt an, ob die auf den Leitungen 48 bis 52 erhaltenen Signale invertiert werden sollen. Es wird in Erinnerung gebracht, daß auf diesen Leitungen nur Signale erhalten werden, wenn ein Fehler auftritt. Dabei sind diese Signale nur wirksam, wenn sich der Fehler auf die ODER-Matrix 7 bezieht, was durch das Signal 54 vom Vergleichsauswerter 46 angegeben wird. Das Signal 54 ist abhängig davon, ob der Testver-

**0 038 947**

gleicher 44 für alle Funktionsleitungen denselben Fehler feststellt (Fehler liegt dann in der UND-Matrix, s. beispielsweise die Phasen 4 und nachfolgende) oder ob das Vergleichsresultat für eine Funktionsleitung einen anderen Wert hat als für alle übrigen (Fehler liegt dann in der ODER-Matrix, s. beispielsweise Phasen 1 und 2). Das Signal INV ist nur in den ersten drei Phasen des Testverfahrens von Bedeutung und kann hiernach beliebige Werte (beispielsweise »1«) annehmen.

— SOLL:

Dieses Signal gibt den Soll-Wert an, mit dem der Vergleicher 44 die Ausgangssignale der Funktionsleitungen vergleichen soll.

— FS SPALTE UND:

Dieses Signal wird in den Phasen oder Schritten verwendet, in denen jeweils eine neue Spalte der UND-Matrix geprüft werden soll.

— FS SPALTE ODER:

Dieses Signal gibt an, wann jeweils eine neue Spalte der ODER-Matrix geprüft werden soll. Beispielsweise werden die beiden vorhergehenden Fortschaltesignale in der Phase 4 verwendet, wo nach jedem Schritt die nächstfolgende Spalte sowohl der UND-Matrix als auch der ODER-Matrix geprüft wird.

— FS Bit:

Dieses Signal wird in dem in der Tabelle II verwendeten Testverfahren verwendet. In jedem Schritt dieses Verfahrens wird ja jeweils eine andere Kippschaltung der UND-Matrix 6 gesetzt. Der Setzzustand einer einzelnen Kippschaltung wird hierbei durch eine Spalte durchgeschoben. Hierauf wird in das Schieberegister der nächsten Spalte eine binäre 1 eingegeben.

— ST ODER:

Dieses Signal setzt alle Kippschaltungen der ODER-Matrix.

— RT UND:

Dieses Signal stellt alle Kippschaltungen der UND-Matrix zurück.

— RT ODER:

Dieses Signal stellt alle Kippschaltungen der ODER-Matrix zurück.

— RT p-ZLR:

Dieses Signal stellt den in Fig. 6 gezeigten Zähler 72 zurück. Dieser Zähler dient zur Definierung der jeweils geprüften Spalte.

— INC — p:

Dieses Signal schaltet den Zähler 72 um eine Einheit weiter.

Die nachfolgend gezeigte Tabelle III (Seite 12) zeigt übersichtlich die Verwendung dieser Steuersignale während der einzelnen Schritte des Testablaufes. Die Auswirkungen dieser Steuersignale werden anhand der Fig. 6 bis 9 verdeutlicht.

0 038 947

Tabelle III
Test-Ablauf

| Phase | Schritt | Test | INV | SOLL | FS Spalte UND | FS Spalte ODER | FS BIT | ST ODER | RT UND | RT ODER | RT p-ZLR | INC-p |
|---|---|---|---|---|---|---|---|---|---|---|---|---|
| 1 | S1 | 1 | 0 | 0 | 0 | 0 | 0 | 0 | 1 | 1 | 0 | 0 |
| 2 | S2 | 1 | 1 | 1 | 0 | 0 | 0 | 1 | 1 | 0 | 0 | 0 |
| 3 | 0 | 1 | 1 | 1 | 0 | 1 | 0 | 0 | 1 | 0 | 1 | 0 |
|  | 1 | 1 | 1 | 1 | 0 | 1 | 0 | 0 | 1 | 0 | 0 | 1 |
|  | . | . | . | . |  |  |  |  |  |  | . | . |
|  | $p-1$ | 1 | 1 | 1 | 0 | 1 | 0 | 0 | 1 | 0 | 0 | 1 |
| 4 | $p$ | 1 | 1 | 0 | 1 | 1 | 0 | 0 | 1 | 1 | 0 | 1 |
|  | $p+1$ | 1 | 1 | 0 | 1 | 1 | 0 | 0 | 0 | 0 | 0 | 1 |
|  | $2p-1$ | 1 | 1 | 0 | 1 | 1 | 0 | 0 | 0 | 0 | 0 | 1 |
| 5 | $2p$ | 1 | 1 | 0 | 0 | 1 | 1 | 0 | 0 | 0 | 0 | 1 |
|  | $2p+1$ | 1 | 1 | 0 | 0 | 0 | 1 | 0 | 0 | 0 | 0 | 0 |
|  | . | . | . | . | . |  |  |  |  |  | . | . |
|  | $2p+n-1$ | 1 | 1 | 0 | 0 | 0 | 1 | 0 | 0 | 0 | 0 | 0 |
| 6 | $2p+n$ | 1 | 1 | 0 | 0 | 1 | 1 | 0 | 0 | 0 | 0 | 1 |
|  | . |  |  |  |  | 0 |  |  |  |  | . | 0 |
|  | $2p+2n-1$ | 1 | 1 | 0 | 0 | 0 | 1 | 0 | 0 | 0 | 0 | 0 |
|  | . | . | . | . |  |  |  |  |  |  | . | . |
| $5+p-1$ | $2p+n(p-1)$ | 1 | 1 | 0 | 0 | 1 0 | 1 | 0 | 0 | 0 | 0 | 1 0 |
|  | . | . | . | . |  | . |  |  |  |  | . | . |
|  | $2p+n \cdot p-1$ | 1 | 1 | 0 | 0 | 0 | 1 | 0 | 0 | 0 | 0 | 0 |

# 0 038 947

Eine »1« in der zuvor gezeigten Tabelle bedeutet, daß das Signal während des betreffenden Schrittes verwendet wird, während eine »0« oder ein leerer Platz bedeutet, daß das Signal nicht verwendet wird.

Fig. 6 zeigt Einrichtungen zum Testen und Laden der PLA, welche die in Fig. 5 gezeigten Steuersignale verwenden. Die Indices m, n, p werden der Kürze halber nachfolgend zur Bildung zusammengesetzter Wörter, wie z. B. p-Zähler, verwendet. Bereits erwähnt wurde der p-Zähler 72, der nach Decodierung seines Zählerstandes im Decodierer 74 eine der Spalten 0 bis p—1 anzeigt. Während des Testverfahrens schaltet dieser Zähler jeweils weiter, wenn das Signal INC — p an ist. Wird während des Testverfahrens ein Testfehler TF festgestellt, so wird der Stand des Zählers 72 in das p-Register 70 abgespeichert. Dieser abgespeicherte Zählerstand kann jederzeit mit dem Signal ST — p in den Zähler 72 geladen werden. Außerdem kann der Zähler durch das Signal RST — p zurückgestellt und vom Signal DEC — p heruntergezählt werden. Während des Ladevorganges adressiert der Zähler 72 den Ladespeicher 76 für die UND-Matrix, von wo jeweils die Daten einer Spalte in das Schieberegister 78 geladen werden. Von diesem Schieberegister können sie über die p-Steuerlogik 80 in die betreffenden Kippschaltungen der angezeigten Spalte in der UND-Matrix 6 geladen werden. Die Steuerlogik 80, die außerdem noch die Steuersignale vom Testspeicher 66 empfängt, soll weiter unten noch näher beschrieben werden.

Neben der Kenntnis der jeweils betrachteten Spalte benötigt man zum Laden auch Einrichtungen, welche die jeweils betrachtete Zeile der insgesamt m-Zeilen der ODER-Matrix 7 anzeigen. Hierzu ist ein Zähler 86 vorgesehen. Der Zähler 86 kann durch das Signal RST — m zurückgestellt und durch das Signal INC — m fortgeschaltet werden.

Wird beispielsweise im Testschritt S1 (Tabelle I) festgestellt, daß eine bestimmte Ausgangsleitung der ODER-Matrix 7 fehlerhaft ist, so wird diese Ausgangsleitung durch ein Signal auf einer der Leitungen 48 bis 52 angezeigt, wie bereits im Zusammenhang mit Fig. 2 beschrieben wurde. Dieses Signal gelangt außerdem zum Codierer 82 in Fig. 6, wo es in eine codierte Darstellung der betreffenden Zeilennummer übersetzt und in das Register 84 geladen werden kann, wenn an diesem Register das Steuersignal »speichere m-Stand« anliegt. Vom Register 84 kann dieser m-Stand in den Zähler 86 geladen werden, wenn das Signal ST — m anliegt. Ähnlich wie bei der UND-Matrix ist auch für die ODER-Matrix ein Decodierer 88 vorgesehen, der hier jedoch die betrachtete Zeile 0 bis m—1 der Matrix 7 angibt. Außerdem ist ein Ladespeicher 90 für die ODER-Matrix vorgesehen, dessen Ausgangssignale in ein Schieberegister 92 geladen werden, von wo aus sie über eine m-Steuerlogik 94 in die Kippschaltungen der betrachteten Zeile in der ODER-Matrix 7 eingeschoben werden können. Die Logik 94 benötigt außerdem Signale, welche den Stand des Zählers 72, den Inhalt des p-Registers 70 sowie den eingeschalteten Ausgang des Decodierers 74 angeben, wie weiter unten noch näher ausgeführt werden wird.

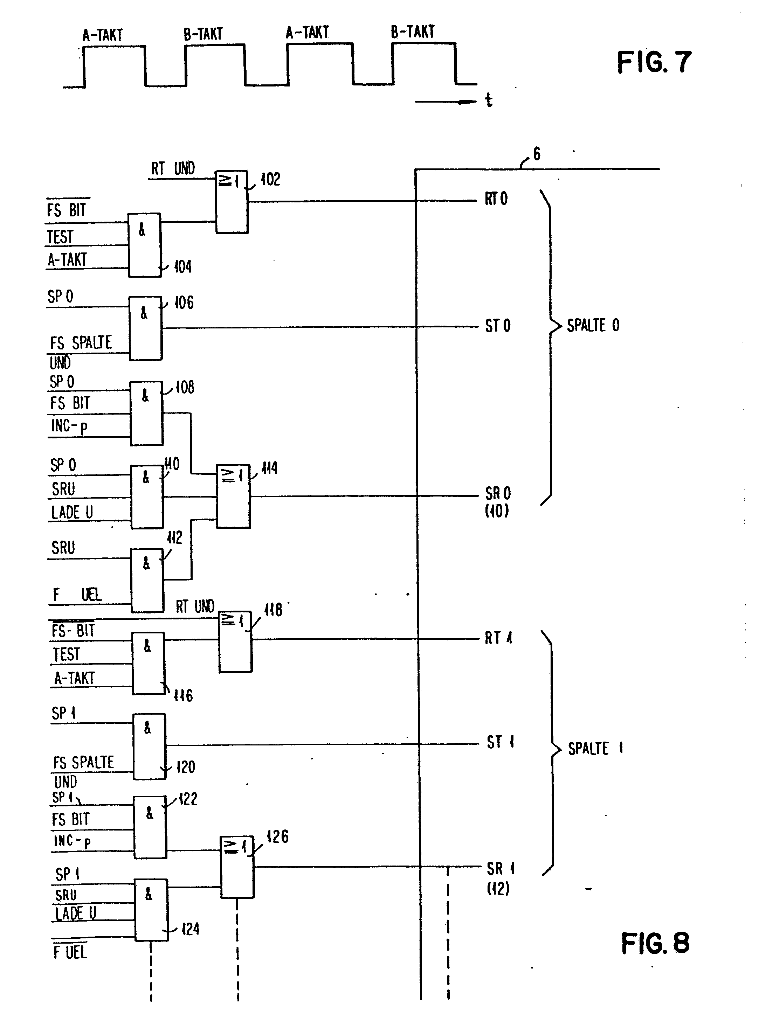

Fig. 7 zeigt eine Einzelheit im zeitlichen Ablauf der einzelnen Testschritte. Generell kann gesagt werden, daß in jedem Schritt des Testverfahrens, d. h. zu jedem Stand des Schrittzählers 64 während des Testverfahrens, ein Test durchgeführt wird. Dieser Test beinhaltet vor allem die Feststellung des Ausgangssignals des Testvergleichers 44. Wird kein Signal TF erhalten, das einen Fehler anzeigt, wird der Schrittzähler 64 um eine Einheit weitergeschaltet und wird in diesem nächsten Schritt wiederum ein Test durchgeführt.

Wie Tabelle I zeigt, muß in manchen Testschritten der Setzzustand von einer Spalte zur nächsten fortgeschaltet werden. Praktisch kann dies so gelöst werden, daß in der ersten zeitlichen Hälfte eines Testschrittes die Matrizen zurückgestellt werden und in der zweiten Hälfte die betreffende neue Spalte gesetzt wird. Fig. 7 zeigt eine solche Aufteilung eines Testschrittes in zwei zeitliche Hälften, die jeweils durch einen entsprechenden Taktimpuls gekennzeichnet sind. Die erste Hälfte wird durch den A-Takt und die zweite Hälfte durch den B-Takt gekennzeichnet. Natürlich ist zur Steuerung der gesamten Fehlererkennungs- und -korrektureinrichtung ein Haupttaktgenerator vorgesehen, wie er üblicherweise für Datenverarbeitungsanlagen verwendet wird. Mit Impulsen, die aus diesem Taktgenerator abgeleitet sind, wird der Schrittzähler 64 fortgeschaltet. Beim Prüfverfahren nach Tabelle II können diese Fortschalteimpulse INCR auch als Schiebeimpulse für das Verschieben des einzelnen gesetzten Bits in den Schieberegistern der UND-Matrix 6 verwendet werden. Die beim Laden der PLA notwendigen Schiebeimpulse zum Laden der Kippschaltungen der PLA werden ebenfalls aus Impulsen des Taktgenerators abgeleitet. Die hierzu notwendigen Taktsteuereinrichtungen sind jedoch an sich bekannt und brauchen hier nicht näher beschrieben zu werden.

Die in Fig. 6 gezeigte p-Steuerlogik 80 soll nun anhand der Fig. 8 genauer beschrieben werden. Die Logik 80 wird von einzelnen, in der Fig. 8 angegebenen Steuersignalen des Testspeichers 66 gesteuert und liefert Rückstell-, Setz- und Ladesignale für jeweils eine Spalte der UND-Matrix 6.

Die Erzeugung dieser Signale ist in Fig. 8 nur für die Spalten 0 und 1 gezeigt; für die Spalten 2 bis p—1 sind die gleichen Einrichtungen wie für die Spalte 1 notwendig.

Die Spalte 0 wird vom Ausgangssignal des ODER-Gliedes 102 zurückgestellt, wenn das Signal RT UND anliegt oder das UND-Glied 104 ein Ausgangssignal liefert. Die Eingänge dieses UND-Gliedes werden gebildet aus dem invertierten Signal FS BIT, dem in der Tabelle III gezeigten Signal TEST und dem in Fig. 7 gezeigten Signal A-Takt. Während der in der Tabelle I gezeigten Testschritte wird also jeweils die nullte Spalte der UND-Matrix in der ersten zeitlichen Hälfte jedes Testschrittes zurückge-

13

stellt.

Die Spalte 0 wird gesetzt, wenn diese Spalte vom Decodierer 74 selektiert wird, d. h. wenn das Signal SP 0 anliegt und das in der Tabelle III gezeigte Signal FS SPALTE UND, wozu das UND-Glied 106 verwendet wird. Das zur nullten Spalte gehörende Schieberegister, das aus den Kippstufen LU 00 bis LU 30 besteht, wird über die Eingangsklemme 10 geladen, wenn vom ODER-Glied 114, das von drei UND-Gliedern 108, 110 und 112 gespeist wird, ein Signal erhalten wird. Die Eingangssignale zum UND-Glied 108 bestehen aus dem Auswahlsignal SP 0, dem Steuersignal FS BIT und dem Steuersignal INC — p. Das UND-Glied 108 liefert also ein Ausgangssignal, jedesmal, wenn in Tabelle II der Setzzustand einer einzelnen Kippschaltung durch alle Kippschaltungen eines Schieberegisters einer bestimmten Spalte durchgewandert ist und nunmehr der Setzzustand in die erste Stufe des Schieberegisters der nächsten Spalte eingespeist werden soll. Dies tritt immer im ersten Schritt einer jeden Phase nach der Tabelle II auf (siehe auch Signal INC — p in Tabelle III). Die beiden anderen UND-Glieder 110 und 112 werden beim Laden der UND-Matrix 6 verwendet. Ihre Funktion soll weiter unten noch beschrieben werden.

Das Rückstellsignal RT1 für die Spalte 1 der Matrix 6 wird von den beiden logischen Gliedern 116 und 118 erzeugt, deren Funktionsweise den beiden logischen Gliedern 104 und 102 entspricht. Das UND-Glied 120 entspricht in seiner Wirkung für die Spalte 1 dem UND-Glied 106 für die Spalte 0. Die drei logischen Glieder 122, 124 und 126 entsprechen in ihrer Wirkung für die Spalte 1 den logischen Gliedern 108, 110 und 114 für die Spalte 0. Das obenerwähnte UND-Glied 112 ist jedoch nur für die Spalte 0 vorgesehen und dient zum Laden der Ersatzleitung UEL, wie weiter unten noch beschrieben werden wird. Die für die Spalte 1 gezeigten logischen Glieder 116 bis 126 sind auch jeweils für die Spalten 2 bis p−1 der UND-Matrix 6 vorhanden, so daß z. B. die Ausgänge der UND-Glieder 104, 116, etc. die gesamte UND-Matrix zurückstellen, wobei das Rückstellen jeder Spalte der Matrix 6, d. h. also der gesamten Matrix 6, zur Zeit des A-Taktes (Fig. 7) erfolgt. Die anderen Eingänge zur Matrix 6, das sind die Leitungen ST 0, SR 0; ST 1, SR 1; usw. für alle übrigen Spalten, werden zur Zeit des B-Taktes wirksam. Vor dem neuen Setzen einer Spalte wird also jeweils die gesamte Matrix zurückgestellt.

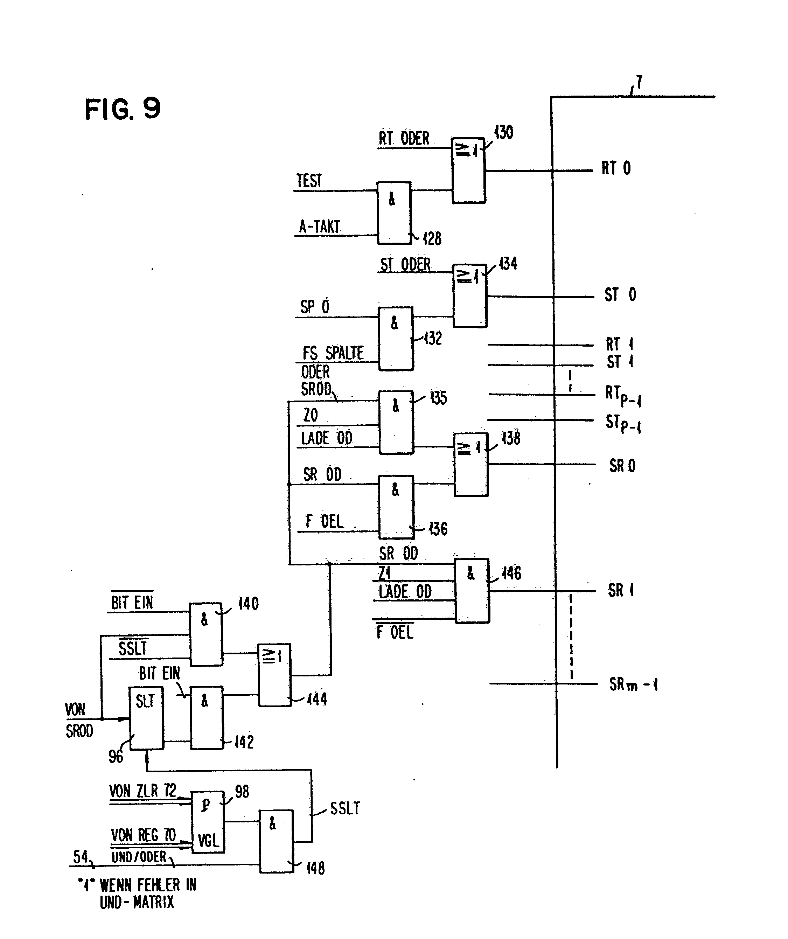

Die in Fig. 6 gezeigte m-Steuerlogik 94 soll nun anhand von Fig. 9 näher beschrieben werden. Für den Prüfvorgang nach den Tabellen I bis III werden lediglich für die Kippschaltungen jeweils einer ganzen Spalte der ODER-Matrix 7 Rückstell- und Setzsignale benötigt. Das Verschieben eines einzelnen Kippschaltungs-Setzzustandes in den Schieberegistern der Matrix 7 wird während des Testverfahrens nicht benötigt, so daß Signale zu den Eingängen der zeilenmäßig angeordneten Schieberegister der Matrix 7 nur während des Ladevorganges der Matrix 7 verwendet werden. Diese Eingangssignale zu den Schieberegistern sind in Fig. 9 mit SR 0, SR 1 bis $SR_{m-1}$ bezeichnet. Ihre Erzeugung soll weiter unten anhand des Ladevorganges noch näher beschrieben werden.

Die Erzeugung eines Rückstellsignals RT 0 für die Kippschaltungen der Spalte 0 in der Matrix 7 wird vom ODER-Glied 130 durchgeführt, das vom Steuersignal RT ODER und vom Ausgang des UND-Gliedes 128 gespeist wird. Die Eingänge zum UND-Glied 128 setzen sich aus dem Steuersignal TEST und dem Signal A-Takt zusammen. Die Einrichtungen zur Erzeugung eines Rückstellsignals TR 1, RT 2, . . . bis $RT_{p-1}$ sind in gleicher Weise mit einem entsprechenden ODER-Glied und einem entsprechenden UND-Glied wie für die Spalte 0 aufgebaut. Die Eingangssignale zu diesen logischen Gliedern sind dieselben wie für Spalte 0. Eine Spalte der ODER-Matrix wird gesetzt, wenn entweder das Gesamt-Setzsignal ST ODER am ODER-Glied 134 anliegt, oder vom UND-Glied 132 ein Signal kommt, wenn eine Spalte — im Falle des UND-Gliedes 132 also die Spalte 0 — selektiert ist und das Fortschaltesignal FS SPALTE ODER anliegt (z. B. Test Phase 3, 4, Schritt 2p, etc.). Für die restlichen Spalten sind den Gliedern 128 bis 134 entsprechende Logikglieder vorgesehen. Der Rest der Fig. 9 wird anhand des Ladevorganges besprochen.

Tabelle IV (Seite 34) zeigt die für den Ladevorgang notwendigen Steuersignale. Wie bereits erwähnt, muß nach jedem Testablauf die PLA neu geladen werden. Wird das Testverfahren routinemäßig, beispielsweise jeweils am Morgen vor dem Einschalten der Anlage durchgeführt, so ist im Normalfall kein Fehler zu erwarten und brauchen die beiden Ersatzleitungen UEL und OEL nicht verwendet zu werden. Ist jedoch der Ladevorgang eine Folge eines vorher durch einen Fehler ausgelösten Testverfahrens, so muß entweder die Ersatzleitung UEL geladen werden, wenn eine Spaltenleitung defekt ist oder die Ersatzleitung OEL, wenn eine Ausgangsleitung der PLA defekt ist, oder entsprechende Transistorfehler vorliegen. Wird die Ersatzleitung UEL aktiviert, so muß in das Schieberegister 0, d. h. in die Stufen LU 00 bis LU 30 das binäre Muster geladen werden, das vorher in dem zur fehlerhaften Spalte gehörenden Schieberegister geladen war. Außerdem müssen in der ODER-Matrix die zur fehlerhaften Spalte gehörenden Stufen auf 0 gesetzt werden und das für diese Stufen vorgesehene binäre Muster in die zur Ersatzleitung UEL gehörenden Stufen LO 00 bis LO 30 geladen werden.

Ist eine Ausgangsleitung AL der ODER-Matrix 7 defekt, so muß das für das Schieberegister der fehlerhaften Zeile vorgesehene binäre Muster in das zur Ersatzleitung OEL gehörende Schieberegister, d. h. in die Stufen LO 00 bis LO 04 geladen werden. Während also die zur Personalisierung und zur Prüfung der PLA dienenden Schieberegister in der UND-Matrix spaltenmäßig angeordnet sind, sind sie in der ODER-Matrix 7 zeilenmäßig angeordnet. Die UND-Matrix weist demnach entsprechend den p-Spalten p-Schieberegister auf, während die ODER-Matrix m-Schieberegister aufweist.

Tabelle IV
LADE-ABLAUF

| | LADE U | LADE OD | BIT EIN | RST-m | RST-p | ST-m | ST-p | SP p-Stand | SP m-Stand | F UEL | F OEL | SCH | INC-m | DEC-p | INC-p | RST-IL |
|---|---|---|---|---|---|---|---|---|---|---|---|---|---|---|---|---|
| LDU1<br>LDU2 | 0<br>0 | 0<br>0 | 0<br>0 | 0<br>1 | 0<br>1 | 0<br>0 | 0<br>0 | 1<br>0 | 1<br>0 | 0<br>0 | 0<br>0 | 0<br>0 | 0<br>0 | 0<br>0 | 0<br>0 | 1<br>0 |
| LADEN SP1 | 1<br>1<br>⋮<br>1 | 0 | 0 | 0 | 0 | 0 | 0 | 0 | 0 | 0 | 0 | 0<br>1<br>⋮<br>1 | 0 | 0 | 1<br>0<br>⋮<br>0 | 0<br><br>0 |
| LADEN SP2 BIS SP p−2 | ⋮ | | | | | | | | | | | | | | | ⋮ |
| LADEN SP p−1 | 1<br>1<br>1 | 0 | 0 | 0 | 0 | 0 | 0 | 0 | 0 | 0 | 0 | 0<br>1<br>1 | 0 | 0 | 1<br>0<br>0 | 0<br>·<br>0 |
| LADEN ERSATZ-LTG UEL | 1<br>1<br>·<br>1 | 0<br><br>0 | 0<br><br>0 | 0<br><br>0 | 0<br><br>0 | 0<br><br>0 | 1<br>0<br>·<br>0 | 0<br><br>0 | 0<br><br>0 | 1<br>1<br>·<br>1 | 0<br><br>0 | 0<br>1<br>1<br>1 | 0<br><br>0 | 0<br><br>0 | 0<br><br>0 | 0<br>·<br>·<br>0 |
| LDO | 0 | 0 | 0 | 0 | 1 | 0 | 0 | 0 | 0 | 0 | 0 | 0 | 0 | 0 | 0 | 0 |
| Zeile 1 | 0<br>·<br>0 | 1<br>·<br>1 | 0<br>·<br>1 | 0 | 0 | 0 | 0 | 0 | 0 | 0 | 0 | 0<br>1<br>·<br>1 | 1<br>0<br>·<br>0 | 1<br>1<br>·<br>1 | 0 | 0 |
| LADEN ZEILEN 2 BIS m−2 | ⋮ | ⋮ | | | | | | | | | | | | | | ⋮ |
| LADEN ZEILE m−1 | 0<br>·<br>0<br>0 | 1<br>·<br>1<br>1 | 0<br>·<br>0<br>1 | 0 | 0 | 0 | 0 | 0 | 0 | 0 | 0 | 0<br>1<br>1<br>1 | 1<br>0<br>0<br>0 | 1<br>1<br>1<br>1 | 0 | 0<br>·<br>·<br>0 |
| LADEN ERSATZ-LTG OEL | 0<br>0<br>·<br>0<br>0 | 1<br>1<br>·<br>1<br>1 | 0<br>0<br>·<br>0<br>1 | 0<br>0<br><br>0<br>0 | 0<br>0<br><br>0<br>0 | 1<br>0 | 0<br>0<br><br>0<br>0 | 0<br>0<br><br>0<br>0 | 0<br>0<br><br>0<br>0 | 0<br>0<br><br>0<br>0 | 1<br>1<br>·<br>1<br>1 | 0<br>1<br>·<br>1<br>1 | 0<br>0<br><br>0<br>0 | 1<br>1<br>·<br>1<br>1 | 0<br>0<br>·<br>0<br>0 | 0<br>0<br>·<br>0<br>0 |

Es soll nun anhand der Tabelle IV das Laden der UND-Matrix 6 beschrieben werden. Zu Tabelle IV sind die hierzu nötigen, vom Testspeicher 66 erzeugten Steuersignale in übersichtlicher Weise aufgeführt. Die Auswirkungen dieser Signale während der einzelnen Schritte des Ladeverfahrens werden anhand der Fig. 6 bis 9 verdeutlicht.

Vor dem Laden der Schieberegister in den einzelnen Spalten der Matrix sind zwei Vorbereitungsschritte LDU1 und LDU2 durchzuführen, um die beim Auftreten eines Fehlersignals TF vorhandenen Fehler-Identifizierungsinformationen abzuspeichern. Im Schritt LDU1 wird der Stand des p-Zählers 72 in das Register 70 übertragen. Ist ein Fehler in der ODER-Matrix 7 festgestellt worden, so gibt ein Signal auf einer der Leitungen 48 bis 52 die betreffende fehlerhafte Ausgangsleitung der Matrix 7 an, der ein bestimmter Wert für den Zeilenindex m entspricht. Die betreffende Leitung 48, 50 oder 52 erzeugt über den Codierer 82 ein binär codiertes Signal, das im Register 84 abgespeichert wird. Ferner wird von der betreffenden Leitung 48, 50 oder 52 die zur fehlerhaften Zeile gehörende Kippschaltung IL zurückgestellt (Signal RST IL).

Im nächsten Schritt LDU2 können nun die beiden Zähler 72 und 86 zurückgestellt werden. Es beginnt nun das Laden der Spalte 1 der UND-Matrix. Da zunächst die Ersatzleitungsspalte 0 nicht geladen wird, wird der p-Zähler 72 durch das Signal INC — p auf 1 fortgeschaltet. Dieser Zähler adressiert nun den Speicher 76, in dem die Ladeinformation für die UND-Matrix 6 gespeichert ist, wonach die betreffende Information für die Spalte 1 in das Schieberegister SRU 78 ausgelesen wird. Das erste Bit zum Laden der ersten Spalte der UND-Matrix steht somit am Ausgang des Schieberegisters 78 zur Verfügung und gelangt über das in Fig. 8 gezeigte UND-Glied 124 und das ODER-Glied 126 zum Eingang 12 des Schieberegisters SR1 der Spalte 1. In den weiteren Schritten zum Laden der ersten Spalte werden Schiebeimpulse SCH dem Schieberegister 78 zugeführt und die betreffenden ausgeschobenen Bits über das UND-Glied 124 in den Eingang 12 des Schieberegisters der ersten Spalte geladen. Das Verschieben des Schieberegisters 78 und des Schieberegisters der ersten Spalte erfolgt synchron.

Nach der ersten Spalte wird die zweite Spalte geladen, wobei im ersten Schritt dieses Ladevorganges der p-Zähler 72 um 1 weitergeschaltet wird und das betreffende erste Bit aus dem Schieberegister 78 zugleich in die UND-Matrix 6 eingelesen wird. Nach dem Einlesen des ersten Bits bleibt der p-Zähler stehen, bis die Spalte geladen ist. Die Spalten 2 bis einschließlich p—1 werden also auf die gleiche Weise geladen wie die Spalte 1. Die Einrichtungen zum Adressieren des Speichers 76, zum Laden des Schieberegisters 78 und zum Verschieben dieses Schieberegisters sind nicht gezeigt, da solche Adressierungs- und Verschiebeeinrichtungen an sich bekannt sind und die Deutlichkeit der Figur vermindern würden. Ähnliches gilt für Einrichtungen zur zeitlichen Steuerung der Übertragung von Daten vom Speicher 76 in die UND-Matrix 6.

Nach der letzten Spalte p—1 wird nun die Ersatzspalte UEL geladen. Ist während des Testablaufes festgestellt worden, daß eine Spaltenleitung der UND-Matrix fehlerhaft ist, so muß die zu dieser Spalte gehörende Information nunmehr in die Ersatzspalte 0 geladen werden. Bei einem Laden der PLA, das nicht im Anschluß an einen aufgetretenen Fehler erfolgt, kann der betreffende Schritt des Ladevorganges eventuell in geeigneter Weise übergangen werden, oder aber einfach die im Speicher LDU 76 zur Spalte 0 geladene Information 00 . . . 0 in das nullte Schieberegister LU 00 bis LU 30 geladen werden. Im ersten Schritt des Ladevorganges der nullten Spalte nach Auftreten eines Fehlers muß der Zähler 72 mit der im p-Register 70 abgespeicherten Information über die fehlerhafte Spalte geladen werden. An das UND-Glied 112 wird das Signal F UEL angelegt, was praktisch die Adresse p = 0 erzwingt, so daß die aus dem Schieberegister 78 ausgelesenen Bits über das UND-Glied 112 und das ODER-Glied 114 in den Eingang 10 des Schieberegisters SRO der nullten Spalte eingelesen werden können. Der weitere Verlauf ist analog zum Laden der Spalten 1 bis p—1. Mit dem im p-Zähler gespeicherten Wert wird der Speicher 76 adressiert und die betreffende Information, die sich auf die fehlerhafte Spalte der UND-Matrix bezieht, wird in das Register 78 geladen, von wo es in die UND-Matrix eingelesen wird. Zu dem zu dieser Spalte gehörenden UND-Glied 124 fehlt jedoch nun der Eingang F̄ UEL, so daß die vom Schieberegister SRU ausgelesene Information über das UND-Glied 112 und das ODER-Glied 114 nicht in die fehlerhafte Spalte, sondern in das Schieberegister 0 eingelesen wird. Ein Laden der fehlerhaften Spalte in der UND-Matrix ist jedoch unschädlich, da diese Spalte in der ODER-Matrix auf 0 zurückgestellt wird.

Die Spalte 0 der Matrix 6 kann jedoch auch durch eine entsprechende Information aus dem Speicher 76 während der Selektion der Spalte 0 (Signal SPO) über das UND-Glied 110 geladen werden.

Nach dem Laden der UND-Matrix 6 wird die ODER-Matrix 7 geladen. In der ODER-Matrix sind jedoch die Schieberegister zeilenmäßig angeordnet, so daß das zuerst in einen der Eingänge 30 bis 36 eingelesene Bit schließlich im Schieberegister LO 04 bis LO 34 der letzten Spalte p—1 gespeichert wird. Die in den Kippschaltungen der nullten Spalte, die zur Ersatzleitung UEL gehört, zu speichernde Information muß also für jedes der zeilenmäßig angeordneten Schieberegister am Schluß eingegeben werden. Beim Laden der ODER-Matrix 7 sind zwei Besonderheiten zu beachten: 1. Das Laden für den Fall, daß eine Spaltenleitung fehlerhaft ist und 2. das Laden für den Fall, daß eine Ausgangsleitung der ODER-Matrix fehlerhaft ist.

Ist eine der spaltenförmigen Produktleitung PL schadhaft, so müssen die zu dieser Produktleitung gehörenden Kippschaltungen in der ODER-Matrix 7 auf 0 zurückgestellt werden und die zuvor in diesen Kippschaltungen abgespeicherte Information in die Kippschaltungen der Spalte 0 abgespeichert werden. Dieses Laden der nullten Spalte der ODER-Matrix 7 erfolgt automatisch während des Ladevorganges der ODER-Matrix. Hierzu wird auf Fig. 9 Bezug genommen und das Laden der ersten Zeile Z1 beschrieben. Als Vorbereitungsschritt LDO 1 ist dabei nur das Zurückstellen des p-Zählers 72 notwendig. Im nächsten Schritt wird der m-Zähler 86, der ja noch stets auf 0 steht, auf 1 weitergeschaltet und somit die erste Zeile der ODER-Matrix adressiert. Der p-Zähler, der auf 0 steht, wird um 1 heruntergezählt, so daß er nun auf Maximalkapazität steht und die Spalte p−1 anzeigt. In den Eingang 32 zum Schieberegister der ersten Zeile wird somit das zur Spalte p−1 zugehörige Bit eingelesen. Hierzu adressiert der Zähler 86 den Ladespeicher LDO 90 der ODER-Matrix, und die zur adressierten Zeile gehörende Information wird in das Schieberegister SROD 92 ausgelesen. Das erste Bit aus diesem Schieberegister gelangt dabei zugleich über das UND-Glied 146 (Fig. 9) zum Schieberegister SR1 der Zeile Z1 der ODER-Matrix. An den Eingängen des UND-Gliedes 146 liegt das Signal Z1 an, da ja der Zähler 86 die erste Zeile anzeigt und der Decodierer 88 dementsprechend durch das Signal Z1 die erste Zeile selektiert. Während des gesamten Ladens der ODER-Matrix ist außerdem das Signal LADE OD an. Der Ladepfad vom Register 92 verläuft in Fig. 9 im Normalfall über das UND-Glied 140 und das ODER-Glied 144. Der Ausgang dieses ODER-Gliedes ist mit UND-Gliedern, wie 146, für alle Zeilen der ODER-Matrix verbunden. Das Signal BIT EIN dient zum Laden der Ersatzleitung OEL und steht also beim normalen Laden der ODER-Matrix 7 auf 0, so daß dieser Eingang zum UND-Glied 140 anliegt. Auch das Signal SSLT, dessen Bedeutung später noch erklärt werden wird, ist während des normalen Ladens der ODER-Matrix auf 0, so daß auch dieser Eingang zum UND-Glied 140 erfüllt ist. Das Laden des Schieberegisters zur ersten Zeile der ODER-Matrix 7 wird sodann dadurch weitergetrieben, daß dem Schieberegister SROD Schiebeimpulse SCH zugeführt werden und der Inhalt des Schieberegisters 92 somit in das zur ersten Zeile gehörende Schieberegister LO 10 bis LO 14 eingelesen wird. Das Laden der übrigen Zeilen 2 bis m−1 erfolgt auf die gleiche Weise, wobei jeweils zu Beginn des Ladens einer Zeile der m-Zähler 36 um 1 weitergeschaltet wird (Signal INC − m), sodann den Speicher 90 adressiert und die betreffende Information in das Schieberegister 92 ausliest, von wo das erste Bit direkt dem betreffenden Eingang 32, 34 oder 36 zugeführt wird. Die weiteren Bits zu dem zu ladenden Schieberegister werden durch Ausschieben des Schieberegisters 92 dem betreffenden Eingang 32, 34 oder 36 zugeführt.

Ist das Laden der ODER-Matrix 7 auf einen Fehler zurückzuführen, der in einer der Produktleitungen PL aufgetreten ist, so muß, wie bereits beschrieben, die betreffende Spalte in der ODER-Matrix 7 auf 0 gesetzt und die betreffende Information in die Spalte 0 geladen werden. Beim Laden der ODER-Matrix wird darum ständig der Stand des herunterzählenden Zählers 72 mit dem im p-Register 70 gespeicherten und die fehlerhafte Spalte angebenden Stand durch den p-Vergleicher 98 (Fig. 9) verglichen. Ist beispielsweise die Produktleitung PL4 fehlerhaft, die der Spalte p−1 entspricht, so wird am Ausgang des Vergleichers 98 ein Signal erhalten, wenn im ersten Ladeschritt einer Zeile der ODER-Matrix das betreffende Bit vom Schieberegister SROD 92 ausgelesen und in die m-Steuerlogik 94 (Fig. 9) eingelesen wird. Auch am zweiten Eingang zum UND-Glied 148 steht ein Signal an, da auf der Leitung 54 (Fig. 2) angezeigt wird, daß ein Fehler in der UND-Matrix 6 aufgetreten ist. Am Ausgang des UND-Gliedes 148 wird somit ein Signal SSLT erhalten, das die Kippschaltung 96 vorbereitet, wodurch das betreffende Bit vom Schieberegister 92 in die Kippschaltung eingelesen werden kann. Zugleich fällt der Eingang $\overline{SSLT}$ zum UND-Glied 140 weg, so daß das betreffende Bit nicht über das UND-Glied 140 gelangen kann. Da außerdem der Eingang BIT EIN zum UND-Glied 142 auf 0 ist, wird von beiden UND-Gliedern 140 und 142 das binäre Signal 0 ausgelesen und dieses 0-Bit somit in den Eingang des Schieberegisters der gerade betrachteten Zeile der UND-Matrix 7 eingelesen. Ist dies die Zeile Z1, so wird somit in der Kippschaltung LO 14 der binäre Wert 0 gespeichert. Im letzten Schritt des Ladevorganges einer Zeile der ODER-Matrix wird die Kippschaltung der nullten Spalte der ODER-Matrix geladen. Im angenommenen Beispiel des Ladens der ersten Zeile wäre das also die Kippschaltung LO 10. Beim letzten Schritt des Ladens des Schieberegisters einer Zeile ist jeweils das Signal BIT EIN auf 1, so daß in Fig. 9 das UND-Glied 142 durchgeschaltet wird und den in der Kippschaltung 96 gespeicherten Wert über das ODER-Glied 144 und über das UND-Glied 146 (sofern die erste Zeile geladen wird) in die Kippschaltung LO 10 gesetzt wird.

Derselbe Vorgang spielt sich beim Laden der zu den restlichen Zeilen 2 bis m−1 gehörenden Schieberegister ab. Immer wenn der Stand es herunterzählenden Zählers 72 mit dem im p-Register 70 abgespeicherten Stand, der die fehlerhafte Spaltenleitung angibt, übereinstimmt, wird das betreffende Bit in der Kippschaltung 96 abgespeichert und statt dessen eine 0 zum betreffenden Eingang 32, 34 oder 36 übertragen. Im letzten Schritt des Ladens des Schieberegisters einer Zeile wird das abgespeicherte Bit aus der Kippschaltung 96 in die Kippschaltung der nullten Spalte der ODER-Matrix 7 gesetzt. Am Ende des Ladevorganges steht somit in der nullten Spalte der ODER-Matrix das binäre Muster, das zuvor in den Kippschaltungen zu der als fehlerhaft erkannten Spaltenleitung gespeichert war. In dieser fehlerhaften Spalte stehen sodann lauter Nullen, so daß die fehlerhafte Leitung keinen Beitrag zum Ausgangssignal der PLA liefern kann.

Als letzte Phase des Ladevorganges soll nunmehr das Laden des zu der Ersatzleitung OEL gehörenden Schieberegisters, das aus den Stufen LO 00 bis LO 04 besteht, beschrieben werden. Zu Beginn dieser Phase wird der im m-Register 84 abgespeicherte Stand, der ja die fehlerhafte Zeilenleitung der ODER-Matrix 7 angibt, in den m-Zähler 86 übertragen, wodurch am Ausgang des Decodierers 88 die betreffende Zeile angezeigt und im Speicher 90 die zu der betreffenden Zeile gehörende Schieberegisterinformation adressiert wird. Ist beispielsweise die Zeile 1 fehlerhaft, erzeugt der Decodierer 88 also das Signal Z1, so kann die aus dem Schieberegister 92 ausgelesene Information dennoch nicht dem Eingang 32 des Schieberegisters der ersten Zeile zugeführt werden, da diesmal das Signal F OEL auf 1 steht und somit ein Eingang zum UND-Glied 146 wegfällt. Schaltet dieses Signal F OEL nunmehr das UND-Glied 136 durch, so daß die aus dem Schieberegister SROD ausgelesene Information über das UND-Glied 136 und das ODER-Glied 138 in den Eingang 30 des Schieberegisters der nullten Zeile eingelesen werden kann. Das weitere Laden des nullten Schieberegisters wird durch Schiebeimpulse SCH zum Schieberegister 92 veranlaßt.

Eine weitere Möglichkeit zum Laden des nullten Schieberegisters ist über die normale Selektion ZO und das UND-Glied 135 gegeben.

Da beim Auftreten eines Fehlers in einer Spaltenleitung die zu dieser fehlerhaften Spalte gehörenden Kippschaltungen in der ODER-Matrix 7 auf 0 gesetzt werden, kann in den zu dieser fehlerhaften Spalte gehörenden Kippschaltungen in der UND-Matrix 6 die ursprüngliche Information stehenbleiben, braucht also nicht gelöscht zu werden.

Im gezeigten Ausführungsbeispiel ist eine Spaltenersatzleitung und eine Zeilenersatzleitung für die ODER-Matrix vorgesehen. Obwohl dies den großen Vorteil mit sich bringt, daß nach dem Auftreten eines Fehlers in der PLA der Betrieb nach der kurzzeitigen Test- und Ladephase wieder fortgesetzt werden kann, so gilt dies natürlich nur für den ersten auftretenden Fehler. Ist eine der Ersatzleitungen auf diese Weise verbraucht, so kann beim nächsten auftretenden Fehler die PLA nicht mehr auf die geschilderte Weise wieder betriebsfähig gemacht werden. Diesem Mangel kann abgeholfen werden, wenn mehrere Spalten- und/oder mehrere Zeilenersatzleitungen vorgesehen werden. Es sind in diesem Falle Einrichtungen notwendig, welche die nächste einzusetzende Ersatzleitung anzeigen. Ferner sind dann auch mehrere Signale F UEL und F OEL, mitsamt den dazugehörigen Torschaltungen, wie z. B. die UND-Glieder 136 und 112 nötig.

Obwohl im gezeigten Ausführungsbeispiel das Laden der einzelnen Schieberegister sowohl der UND-Matrix als auch der ODER-Matrix nacheinander erfolgte, ist es klar, daß dieses Laden für alle Schieberegister gleichzeitig erfolgen kann, wobei eventuell nur die in den Speichern 76 und 90 abgespeicherte Ladeinformation seriell ausgelesen werden muß.

Da die in den Fig. 5 bis 9 gezeigte Fehlererkennungs- und -korrektureinrichtung und Ladeeinrichtung nur sporadisch und kurzzeitig eingesetzt wird, genügt es, für eventuell mehrere vorhandene PLA's eine einzige solche Einrichtung vorzusehen, wobei allenfalls der Ladespeicher 68 für jede PLA getrennt vorgesehen werden muß.

**Patentansprüche**

1. Programmierbare logische Anordnung (PLA) mit einer UND-Matrix und einer ODER-Matrix, die durch Produktleitungen miteinander verbunden sind, mit Speicher-Kippschaltungen in den Kreuzungspunkten der Matrizen, sowie mit einer Einrichtung zum Laden und Testen der PLA, dadurch gekennzeichnet,
daß zum Laden und Testen der PLA (Fig. 2) jeweils die zu einer Produktleitung (PL) gehörenden Kippschaltungen (z. B. LU 04 bis LU 34) der UND-Matrix (6) und die zu einer Ausgangsleitung (AI) gehörenden Kippschaltungen (z. B. LO 10 bis LO 14) der ODER-Matrix (7) zu Schieberegistern zusammengefaßt sind,
daß jeweils für die zu einer Produktleitung (PL) gehörenden Kippschaltungen sowohl der UND-Matrix als auch der ODER-Matrix eine gemeinsame Setz- und Rückstelleitung (ST UO/RT UO, usw. bzw. ST 00/RT 00, usw.) vorgesehen ist,
daß sowohl zu den Produktleitungen als auch zu den Ausgangsleitungen je eine oder mehrere, ebenfalls mit Kippschaltungen verbundene Ersatzleitungen (UEL bzw. OEL) vorgesehen sind,
und daß eine Umschalteinrichtung (IL1—3; 38, 40; 42) vorgesehen ist, welche eine von der Einrichtung zum Laden und Testen (44, 46; Fig. 5, 6) als fehlerhaft getestete Ausgangsleitung (AL) durch eine Ersatzleitung (OEL) ersetzt.

2. Anordnung nach Anspruch 1, dadurch gekennzeichnet, daß zur Steuerung des Testablaufes und des Ladeablaufes ein Schrittzähler (64, Fig. 5) vorgesehen ist, der einen Testspeicher (66) und einen Ladespeicher (68) adressiert, wobei der Zähler beim Auftreten eines Fehlers in der PLA auf die Beginnadresse (S1, Tabelle III) des Testablaufes und nach Abschluß des Testauflaufes oder bei Feststellung eines Testfehlers auf die Beginnadresse (LD U1, Tabelle IV) des Ladeablaufes gesetzt wird, und wobei der Testspeicher (66) Steuersignale zum Ansteuern der Setz- und Rückstelleingänge der PLA, und der Ladespeicher (68) Daten zum Laden der PLA abgeben.

3. Anordnung nach Anspruch 1, gekennzeichnet durch einen Testvergleicher (44, Fig. 2), welcher die Ausgangssignale der PLA mit Soll-Werten vergleicht sowie durch einen Vergleichsauswerter (46), der über eine Signalleitung (54) anzeigt, ob bei Auftreten eines Testfehlers (TF) der Testvergleicher (44) Nichtübereinstimmung aller Ausgangssignale der PLA mit dem Soll-Wert, oder nur Nichtübereinstimmung des Signals auf einer einzelnen Ausgangsleitung der PLA mit dem Soll-Wert festgestellt hat,

**0 038 947**

was im ersten Fall einen Fehler in der UND-Matrix bzw. im zweiten Fall einen Fehler in der ODER-Matrix anzeigt (siehe Tabellen I und II).

4. Anordnung nach Anspruch 3, dadurch gekennzeichnet, daß der Vergleichsauswerter (46) eine der Anzahl der Ausgangsleitungen entsprechende Anzahl von Anzeigeleitungen (48, 50, 52) aufweist, wobei eine und nur eine dieser Leitungen bei einem Fehler in der ODER-Matrix anzeigt, welche Ausgangsleitung (AL1 bis AL3) fehlerhaft ist und eine der fehlerhaften Leitung in der Umschalteinrichtung zugeordnete Kippschaltung (IL1 bis IL3) zurückstellt, derart, daß mit Hilfe von Logikgliedern (38, 40, 42) in der Umschalteinrichtung die fehlerhafte Ausgestaltung ausgeschaltet und dafür die ODER-Ersatzleitung (OEL) eingeschaltet wird.

5. Anordnung nach Anspruch 2, gekennzeichnet durch eine erste Steuerlogik (80, Fig. 6, 8) zur spaltenweisen Ansteuerung der UND-Matrix (6) und durch eine zweite Steuerlogik (94, Fig. 6, 9) zur spalten- und zeilenweisen Ansteuerung der ODER-Matrix (7), wobei diese Logikeinrichtungen (80, 94) die Steuersignale vom Testspeicher (66) empfangen und Setz-, Rückstell- und Ladesignale an die Matrizen liefern.

6. Anordnung nach Anspruch 5, gekennzeichnet durch einen ersten Zähler (72, Fig. 6), dessen Ausgangssignale bei Auftreten eines Testfehlers (TF) in ein angeschlossenes erstes Register (70) geladen werden können und der einen ersten Decodierer (74) zur Ansteuerung jeweils einer Spalte der PLA ansteuert sowie durch einen zweiten Zähler (86), dessen Ausgangssignale bei Auftreten eines Testfehlers (TF) in ein angeschlossenes zweites Register (84) geladen werden kann und der einen zweiten Decodierer ansteuert, der jeweils eine Zeile der ODER-Matrix (7) ansteuert.

7. Anordnung nach Anspruch 6, gekennzeichnet durch einen Codierer (82, Fig. 6), der das auf einer der drei Anzeigeleitungen (48, 50, 52) des Vergleichsauswerters (46) erhaltene Signal in eine codierte Darstellung der betreffenden Zeile übersetzt und dessen Ausgang mit einem weiteren Eingang des zweiten Registers (84) verbunden ist.

8. Anordnung nach Anspruch 6, dadurch gekennzeichnet,
daß der erste Zähler (72) einen Ladespeicher (76) für die UND-Matrix (6) adressiert, dessen Ausgang mit einem ersten Schieberegister (78, Fig. 6) verbunden ist, dessen Ausgang über die erste Steuerlogik (80) mit dem Eingang des durch den ersten Decodierer (74) angezeigten Schieberegisters (SR) der UND-Matrix verbindbar ist und dadurch,
daß der Ausgang des ersten Zählers (86) einen Ladespeicher (90) für die ODER-Matrix (7) adressiert, dessen Ausgang mit einem zweiten Schieberegister (92) verbunden ist, dessen Ausgangssignal über die zweite Steuerlogik (94) mit dem Eingang des durch den zweiten Decodierer (88) angezeigten Schieberegisters (92) der ODER-Matrix (7) verbindbar ist.

9. Anordnung nach Anspruch 8, dadurch gekennzeichnet, daß der Ausgang des zweiten Schieberegisters (92) mit dem Eingang eines ersten UND-Gliedes (140, Fig. 9) und dem Eingang einer Kippschaltung (96, Fig. 9) verbunden ist, deren Ausgang über ein zweites UND-Glied (142) mit einem Eingang eines ersten ODER-Gliedes (144) verbunden ist, dessen anderer Eingang mit dem Ausgang des ersten UND-Gliedes (140) verbunden ist, wobei ein Vorbereitungseingang der Kippschaltung mit dem Ausgang eines dritten UND-Gliedes (148) verbunden ist, dessen beide Eingänge mit der Signalleitung (54) des Vergleichsauswerters (46) und mit dem Ausgang eines ersten Vergleichers (98) verbunden ist, wobei die beiden Vergleichseingänge des Vergleichers mit dem Ausgang des vom Maximum herunterzählenden ersten Zählers (72) mit dem Ausgang des zugehörigen ersten Registers (70) verbunden sind, derart, daß beim normalen Ladevorgang das vom zweiten Schieberegister (92) ausgelesene Bit über das erste UND-Glied (140) in das betreffende Schieberegister der ODER-Matrix (7) eingelesen wird, daß jedoch das zu ladende Bit in der Kippschaltung (96) gespeichert wird, wenn der erste Vergleicher (98) ein Ausgangssignal liefert und über die Signalleitung (54) ein Fehler in der UND-Matrix (6) festgestellt wurde, so daß zu diesem Zeitpunkt eine binäre Null über das erste ODER-Glied (144) in die ODER-Matrix geladen wird und die zur fehlerhaften Spalte gehörenden Kippschaltungen der ODER-Matrix mit binären Nullen geladen werden.

10. Anordnung nach Anspruch 9, dadurch gekennzeichnet, daß beim letzten Ladeschritt eines Schieberegisters der ODER-Matrix ein erstes Freigabesignal erzeugt wird, welches den Ausgang der Kippschaltung (96) über das erste ODER-Glied (144) zur Kippschaltung der nullten Spalte der ODER-Matrix (7) durchschaltet, derart, daß die zur nullten Spalte (Fig. 2, ganz links) gehörenden Kippschaltungen (LO 00 bis LO 30) der ODER-Matrix mit dem ursprünglichen Inhalt der Kippschaltungen der fehlerhaften Spalte geladen werden.

11. Anordnung nach Anspruch 7, dadurch gekennzeichnet,
daß zum Laden der Ersatzleitung (OEL) der ODER-Matrix (7) der Inhalt des zweiten Registers (84) in den zweiten Zähler (86) übertragen wird und
daß durch ein zweites Freigabesignal (F OEL) ein viertes UND-Glied (136) aktiviert wird, welches den Ausgang des zweiten Schieberegisters (92) über das vierte UND-Glied zum Eingang (30) des zur Ersatzleitung gehörenden Schieberegisters (SRO, LO 00 bis LO 04) durchschaltet.

12. Anordnung nach Anspruch 6, dadurch gekennzeichnet,
daß zum Laden des zur UND-Ersatzleitung (UEL) gehörenden Schieberegisters (LU 00 bis LU 30) der im ersten Register (70) gespeicherte Zählerstand in den ersten Zähler (72) übertragen wird und
daß durch ein drittes Freigabesignal (F UEL) ein fünftes UND-Glied (112, Fig. 8) durchgeschaltet wird,

19

so daß der Ausgang des ersten Schieberegisters (78) über das fünfte UND-Glied mit dem Eingang (10) des Schieberegisters der UND-Ersatzleitung (UEL) verbunden wird.

13. Anordnung nach Anspruch 1, dadurch gekennzeichnet, daß die Kippschaltungen (LU) der UND-Matrix (6) jeweils mit einem ersten Eingang einer UND-Schaltung (58, Fig. 3A) verbunden sind, deren zweiter, invertierender Eingang mit einer Eingangsleitung der PLA und deren Ausgang (Q) mit der Basis eines Transistors (T) verbunden ist, dessen Kollektor mit einer Produktleitung (PL) und dessen Emitter mit Nullpotential verbunden ist.

14. Anordnung nach Anspruch 1, dadurch gekennzeichnet, daß die Kippschaltungen (LO) der ODER-Matrix (7) jeweils mit einem ersten Eingang einer UND-Schaltung (62, Fig. 4A) verbunden sind, deren zweiter Eingang mit einer Produktleitung und deren Ausgang (Q) mit der Basis eines Transistors (T) verbunden ist, dessen Kollektor mit einer Ausgangsleitung (AL) der PLA und dessen Emitter mit Nullpotential verbunden ist.

## Claims

1. A programmable logic array (PLA) having an AND array and an OR array interconnected by means of product lines; storage flip-flop circuits at the cross points of the arrays, and means for loading and testing the PLA, characterized in that for loading and testing the PLA (fig. 2), the flip-flop circuits (e. g., LU 04 to LU 34) of the AND array (6) belonging to a product line (PL) and the flip-flop circuits (e. g., LO 10 to LO 14) of the OR array (7) belonging to an output line (AL) are combined in the form of shift registers, that a common set and reset line (ST UO/RT UO, etc., and ST 00/RT 00, etc., respectively) is provided for the flip-flop circuits of the AND array as well as the OR array belonging to a product line (PL), that one dummy line each or several dummy lines (UEL and OEL, respectively) are provided for the produkt lines as well as the output lines, and that a circuit means (IL1—3; 38, 40; 42) is provided replacing an erroneous output line (AL) detected by the means for loading and testing (44, 46; fig. 5, 6) by a dummy line (OEL).

2. The array according to claim 1, characterized in that for controlling the test sequence and the load sequence, a step counter (64, fig. 5) is provided adressing a test storage (66) and a load storage (68), wherein the counter, upon the occurrence of an error in the PLA, is set to the beginning address (S1, table III) of the test sequence and, after completion of the test sequence or upon detection of a test error, to the beginnung address (LD U1, table IV) of the load sequence, and wherein the test storage (66) emits control signals for adressing the set and reset inputs of the PLA, and the load storage (68) emits data for loading the PLA.

3. The array according to claim 1, characterized by a test comparator (44, fig. 2) comparing the output signals of the PLA with desired values, and a comparison evaluator (46) indicating on a signal line (54) whether, upon the occurrence of a test error (TF), the test comparator (44) has determined a mismatch of all output signals of the PLA and the desired value, or only a mismatch of the signal on a single output line of the PLA and the desired value, the former case being indicative of an error in the AND array and the second case being indicative of an error in the OR array (see tables I and II).

4. The array according to claim 3, characterized in that the comparison evaluator (46) comprises a number of indicator lines (48, 50, 52), wherein, in the case of an error in the OR array, one and only one of said lines indicates which output line (AL1 to AL3) is erroneous, resetting a flip-flop circuit (IL1 to IL3) associated with the erroneous line in the circuit means such that by means of logic gates (38, 40, 42) in said circuit means the erroneous output line is switched off and the OR dummy line (OEL) is switched on instead.

5. The array according to claim 2, characterized by a first control logic (80, fig. 6, 8) for column addressing of the AND array (6) and by a second control logic (94, fig. 6, 9) for column and row addressing of the OR array (7), said logic means (80, 94) receiving the control signals from the test storage (66) and supplying set, reset and load signals to the arrays.

6. The array according to claim 5, characterized by a first counter (72, fig. 6), the output signals of which, upon the occurrence of a test error (TF), can be loaded into a connected first register (70), and which addresses a first decoder (74) for addressing one column each of the PLA, as well as by a second counter (86), the output signals of which, upon the occurrence of a test error (TF), are loaded into a connected second register (84) and which addresses a second decoder which addresses one line each of the OR array (7).

7. The array according to claim 6, characterized by a coder (82, fig. 6) converting the signal received on one of the three indicator lines (48, 50, 52) of the comparison evaluator (46) into a coded representation of the respective line, and the output of which is connected to a further input of the second register (84).

8. The array according to claim 6, characterized in that the first counter (72) addresses a load storage (76) for the AND array (6), the output of which is connected to a first shift register (78, fig. 6), whose output, via the first control logic (80), can be connected to the input of the shift register (SR) of the AND array indicated by the first decoder (74), and that the output of the first counter (86) addresses a load storage (90) for the OR array (7), whose output is connected to a second shift register (92), the output signal of which, via the second control logic (94), can be connected to the input of the shift register (92) of the OR array (7) indicated by the second decoder (88).

9. The array according to claim 8, characterized in that the output of the second shift register (92) is connected to the input of a first AND gate (140, fig. 9) and the input of a flip-flop circuit (96, fig. 9), the output of which, via a second AND gate (142), is connected to one input of a first OR gate (144), the other input of which is connected to the output of the first AND gate (140), wherein an enable input of the flip-flop circuit is connected to the output of a third AND gate (148), the two inputs of which are connected to the signal line (54) of the comparison evaluator (46) and to the output of a first comparator (98), wherein the two compare inputs of the comparator are connected to the output of the first counter (72) counting downwards from the maximum value and to the output of the appertaining first register (70) such that during the normal load process, the bit read from the second shift register (92) is read, via the first AND gate (140), into the respective shift register of the OR array (7), but that the bit to be loaded is stored in the flip-flop circuit (96) if the first comparator (98) supplies an output signal and an error in the AND array (6) was detected via the signal line (54), so that at that time a binary zero is loaded, via the first OR gate (144), into the OR array, and the flip-flop circuits of the OR array belonging to the erroneous column are loaded with binary zeroes.

10. The array according to claim 9, characterized in that during the last load step of a shift register of the OR array, a first force signal is generated, switching the output of the flip-flop circuit (96), via the first OR gate (144), to the flip-flop circuit of the zeroth column of the OR array (7) such that the flip-flop circuits (LO 00 to LO 30) of the OR array belonging to the zeroth column (fig. 2, left-most part) are loaded with the original contents of the flip-flop circuits of the erroneous column.

11. The array according to claim 7, characterized in that for loading the dummy line (OEL) of the OR array (7), the contents of the second register (84) are transferred to the second counter (86), and that by a second force signal (F OEL), a fourth AND gate (136) is activated, switching the output of the second shift register (92), via the fourth AND gate, to the input (30) of the shift register (SRO, LO 00 to LO 04) belonging to the dummy line.

12. The array according to claim 6, characterized in that for loading the shift register (LU 00 to LU 30) belonging to the AND dummy line (UEL), the count stored in the first register (70) is transferred to the first counter (72), and that by a third force signal (F UEL), a fifth AND gate (112, fig. 8) is switched, so that the output of the first shift register (78) is connected, via the fifth AND gate, to the input (10) of the shift register of the AND dummy line (UEL).

13. The array according to claim 1, characterized in that the flip-flop circuits (LU) of the AND array (6) are connected in each case to a first input of an AND gate (58, fig. 3A), the second, inverting input of which is connected to an input line of the PLA, and the output (Q) of which is connected to the base of a transistor (T), whose collector is connected to a product line (PL), and whose emitter is connected to zero potential.

14. The array according to claim 1, characterized in that the flip-flop circuits (LO) of the OR array (7) are connected in each case to a first input of an AND gate (62, fig. 4A), the second input of which is connected to a product line, and the output (Q) of which is connected to the base of a transistor (T), whose collector is connected to an output line (AL) of the PLA, and whose emitter is connected to zero potential.

**Revendications**

1. Réseau logique programmable (PLA) comportant une matrice ET et une matrice OU, qui sont reliées entre elles par l'intermédiaire de lignes de produits, ainsi que des circuits à bascule bistable de mémoire situés au niveau des points d'intersection des matrices, ainsi qu'un dispositif pour charger et tester le réseau PLA, caractérisé en ce que pour charger et tester le réseau PLA (figure 2), les circuits à bascule bistable (par exemple LU 04 à LU 34) de la matrice ET (6), qui sont associés à une ligne de produits (PL), et les circuits à bascule bistable (par exemple LO 10 à LO 14) de la matrice OU (7), qui sont associés à une ligne de sortie (AL), sont réunis pour former des registres à décalage, qu'il est prévu, respectivement pour les circuits à bascule bistable associés à une ligne de produits (PL), ainsi que pour la matrice ET et pour la matrice OU, une ligne commune de positionnement et de remise à l'état initial (ST UO/RT UO, etc. et ST 00/RT 00, etc.), qu'il est prévu aussi bien pour les lignes de produits que pour les lignes de sortie, respectivement une ou plusieurs lignes de secours (UEL ou OEL) reliées également à des circuits à bascule bistable, et qu'il est prévu un dispositif de commutation (IL1—3; 38, 40; 42) qui remplace une ligne de sortie (AL) qui est testée comme étant défectueuse par le dispositif servant à réaliser la charge et le test (44, 46; figures 5, 6), par une ligne de secours (OEL).

2. Dispositif selon la revendication 1, caractérisé en ce que pour réaliser la commande du cycle d'essai et du cycle de charge, il est prévu un compteur pas-à-pas (64, figure 5) qui adresse une mémoire d'essai (66) et une mémoire de charge (68), et que lors de l'apparition d'un défaut dans le réseau PLA, le compteur est positionné sur l'adresse de départ (S1, tableau III) du cycle d'essai et, à la fin du cycle d'essai ou bien lors de la détermination d'un défaut lors de l'essai, sur l'adresse de départ (LD U1, tableau IV) du cycle de charge, et que la mémoire d'essai (66) délivre des signaux de commande servant à commander les entrées de positionnement et de remise à l'état initial du réseau PLA, et la mémoire de charge (68) délivre des données servant à charger le réseau PLA.

3. Dispositif selon la revendication 1, caractérisé par un comparateur d'essai (44, figure 2), qui compare les signaux de sortie du réseau PLA à des valeurs de consigne, et par un dispositif (46) d'exploitation du résultat de comparaison, qui indique par l'intermédiaire d'une ligne (54) de transmission de signaux si, lors de l'apparition d'un défaut (TF) lors de l'essai, le comparateur d'essai (44) a établi une non-coïncidence de tous les signaux de sortie du réseau PLA avec la valeur de consigne ou bien seulement une non-coïncidence du signal présent dans une ligne individuelle de sortie du réseau PLA avec la valeur de consigne, ce qui indique dans le premier cas qu'il existe un défaut dans la matrice ET et dans le second cas qu'il existe un défaut dans la matrice OU (voir les tableaux I et II).

4. Dispositif selon la revendication 3, caractérisé en ce que le dispositif (46) d'exploitation du résultat de comparaison comporte un nombre, correspondant au nombre des lignes de sortie, de lignes d'affichage (48, 50, 52) dont une et une seulement indique, dans le cas d'un défaut dans la matrice OU, quelle ligne de sortie (AL1 à AL3) est défectueuse et ramène à l'état initial un circuit à bascule bistable (IL1 à IL3) associé à la ligne défectueuse dans le dispositif de commutation, de telle sorte qu'à l'aide de circuits logiques (38, 40, 42) situés dans le dispositif de commutation, cette ligne de sortie défectueuse est débranchée et, à sa place, la ligne de secours OU (OEL) est branchée.

5. Dispositif selon la revendication 2, caractérisé par un premier circuit logique de commande (80, figures 6, 8) servant à réaliser la commande de la matrice ET (6) selon les colonnes, et par un second circuit logique de commande (94, figures 6, 9) servant à réaliser la commande de la matrice OU (7) selon les colonnes et selon les lignes, ces circuits logiques (80, 94) recevant les signaux de commande provenant de la mémoire d'essai (66) et envoyant des signaux de positionnement, des signaux de remise à l'état initial et des signaux de charge aux matrices.

6. Dispositif selon la revendication 5, caractérisé par un premier compteur (72, figure 6) dont les signaux de sortie peuvent être chargés dans un premier registre raccordé (70), lors de l'apparition d'un défaut (TF) lors de l'essai, et qui commandent un premier décodeur (74) servant à commander respectivement une colonne du résseau PLA, ainsi que par un second compteur (86), dont les signaux de sortie peuvent être introduits dans un second registre raccordé (84), lors de l'apparition d'un défaut (TF) lors de l'essai, et qui commande un second décodeur qui commande respectivement une ligne de la matrice OU (7).

7. Dispositif selon la revendication 6, caractérisé par un codeur (82, figure 6), qui convertit le signal, qui est obtenu dans l'une des trois lignes d'affichage (48, 50, 52) du dispositif (46) d'exploitation des résultats de la comparaison, en une représentation codée des lignes concernées, et dont la sortie est reliée à une autre entrée du second registre (84).

8. Dispositif selon la revendication 6, caractérisé en ce que le premier compteur (72) adresse une mémoire de charge (76) prévue pour la matrice ET (6) et dont la sortie est reliée à un premier registre à décalage (78, figure 6), dont la sortie peut être reliée par l'intermédiaire du premier circuit logique de commande (80) à l'entrée du registre à décalage (SR), indiqué par le premier décodeur (74), de la matrice ET, et que la sortie du premier compteur (86) adresse une mémoire de charge (90) prévue pour la matrice OU (7) et dont la sortie est reliée à un second registre à décalage (92), dont le signal de sortie eut être transmis par l'intermédiaire du second circuit logique (94) à l'entrée du registre à décalage (92), indiqué par le second décodeur (88), de la matrice OU (7).

9. Dispositif selon la revendication 8, caractérisé en ce que la sortie du second registre à décalage (92) est reliée à l'entrée d'un premier circuit ET (140, figure 9) et à l'entrée d'un circuit à bascule bistable (96, figure 9), dont la sortie est reliée par l'intermédiaire d'un second circuit ET (142) à une entrée d'un premier circuit OU (144), dont l'autre entrée est raccordée à la sortie du premier circuit ET (140), et qu'une entrée de préparation du circuit à bascule bistable est reliée à la sortie d'un troisième circuit ET (148), dont les deux entrées sont reliées à la ligne (54) de transmission de signaux du dispositif (46) d'exploitation du résultat de comparaison et à la sortie d'un premier comparateur (98), les deux entrées de comparaison du comparateur étant reliées à la sortie du premier compteur (72), effectuant un comptage régressif à partir du maximum, et à la sortie du premier registre associé (70), de telle sorte que dans le cas du processus normal de charge, le bit lu hors du second registre à décalage (92) est introduit par l'intermédiaire du premier circuit ET (140) dans le registre à décalage concerné de la matrice OU (7), mais que le bit devant être chargé est mémorisé dans le circuit à bascule bistable (96) lorsque le premier comparateur (98) délivre un signal de sortie et que par l'intermédiaire de la ligne (54) de transmission de signaux, un défaut dans la matrice ET (6) a été établi, de sorte qu'à cet instant un zéro binaire est chargé par l'intermédiaire du premier circuit OU (144) dans la matrice OU et que les circuits à bascule bistable, associés à la colonne défectueuse, de la matrice OU sont chargés par les zéros binaires.

10. Dispositif selon la revendication 9, caractérisé en ce que, lors du dernier pas de charge d'un registre à décalage de la matrice OU se trouve produit un premier signal de libération qui interconnecte directement la sortie du circuit à bascule bistable (96), par l'intermédiaire du premier circuit OU (144), au circuit à bascule bistable de la colonne annulée de la matrice OU (7), de telle sorte que les circuits à bascule bistable (LO 00 à LO 30) de la matrice OU, qui sont associés à la colonne annulée (figure 2, complètement à gauche) sont chargés par le contenu initial des circuits à bascule bistable de

22

la colonne défectueuse.

11. Dispositif selon la revendication 7, caractérisé en ce que pour réaliser le chargement de la ligne de secours (OEL) de la matrice OU (7), le contenu du second registre (84) est transmis dans le second compteur (86) et qu'un quatrième circuit ET (136) est activé par un second signal de libération (F OEL), qui interconnecte directement la sortie du second registre à décalage (92), par l'intermédiaire du quatrième circuit ET, à l'entrée (30) du registre à décalage (SRO, LO 00 à LO 04) associé à la ligne de secours.

12. Dispositif selon la revendication 6, caractérisé en ce que pour réaliser le chargement du registre à décalage (LU 00 à LU 30), associé à la ligne de secours ET (UEL), l'état de comptage mémorisé dans le premier registre (70) est transféré dans le premier compteur (72) et qu'au moyen d'un troisième signal de libération (F UEL), un cinquième circuit ET (112, figure 8) est interconnecté directement de sorte que la sortie du premier registre à décalage (78) est reliée par l'intermédiaire du cinquième circuit ET à l'entrée (10) du registre à décalage de la ligne de secours ET (UEL).

13. Dispositif selon la revendication 1, caractérisé en ce que les circuits à bascule bistable (LU) de la matrice ET (6) sont reliés respectivement à une première entrée d'un circuit ET (58, figure 3A), dont la seconde entrée inverseuse est reliée à une ligne d'entrée du réseau PLA et dont la sortie (Q) est reliée à la base d'un transistor (T), dont le collecteur est raccordé à une ligne de produits (PL) et dont l'émetteur est placé au potentiel nul.

14. Dispositif selon la revendication 1, caractérisé en ce que les circuits à bascule bistable (LO) de la matrice OU (7) sont reliés respectivement à une première entrée d'un circuit ET (62, figure 4A), dont la seconde entrée est reliée à une ligne de produits et dont la sortie (Q) est reliée à la base d'un transistor (P), dont le collecteur est relié à une ligne de sortie (AL) du réseau PLA et dont l'émetteur est placé au potentiel nul.

## FIG. 1

```
1 ──[ ROS ]

2 ──[ I-REG │ P ]

3 ──[ PLA ]

4 ──[ PT-SCH ]

        [ = 1 ]── 5

         CH
```

## FIG. 3B

EINGANGSLEITUNG

```
    [ LU ]   [ & ]   ── T
     56   Q   58

              PL
```

| PL | EINGERASTET | TRANSISTOR T |
|----|-------------|--------------|
| GND | AUF 0 | KURZSCHLUSS |
| ⊕ | AUF 1 | UNTERBRECHUNG |

## FIG. 4A

```
  ⊕
  [ R ]
         AL      PL
       1 - GND
         62  [ & ]  T
   [ LO ]
    60   Q
```

## FIG. 3C

| EIN | LU | T | PL |
|-----|-----|-------|-----|
| 0 | 0 | OFFEN | ⊕ |
| 0 | 1 | LTD | GND |
| 1 | 0 | OFFEN | ⊕ |
| 1 | 1 | OFFEN | ⊕ |

## FIG. 4B

| AL | EINGERASTET | TRANSISTOR T |
|----|-------------|--------------|
| ⊕ | AUF 0 | UNTERBRECHUNG |
| GND | AUF 1 | KURZSCHLUSS |

## FIG.4C

| PL | LO | T | AL |
|-----|-----|-------|-----|
| 0 | 0 | OFFEN | ⊕ |
| 0 | 1 | OFFEN | ⊕ |
| 1 | 0 | OFFEN | ⊕ |
| 1 | 1 | LTD | GND |

FIG. 2

0 038 947

# FIG. 5

Diagram showing blocks: SCHRITT ZLR (64), with inputs INCR, CH ST/SI-ADR, TEST-FLR TF ST/LADEBEGINN-ADR LDU1. Outputs to TEST-SPEICHER (66) and LADE-SPEICHER (68). STEUERSIGNALE above, LADEDATEN below.

# FIG. 6

Block diagram with: TF SPEICH. P-STAND, P REG (70), P ZLR (72) with INC-p, DEC-p, ST/p, RST/p; DEC (74) with outputs SP0, SP1 ... SPp-1; LDU (76); SRU (78) with SCH input; P STR LOGIK (80) FIG. 8; PLA UND (6), ODER (7).

Lower section: COD (82), REG (84) with SPEICH. m-STD., ZLR (86) with INC-m, ST/m, RST/m; DEC (88) with Z0, Z1 ... Zm-1; LDO (90); SR OD (92) with SCH; m STR LOGIK (94) FIG. 9, VON REG. 70.

Reference: 48,50,52

O 038 947

FIG. 7

A-TAKT  B-TAKT  A-TAKT  B-TAKT

→ t

FIG. 8

31

# FIG. 9